# EUROPÄISCHE PATENTSCHRIFT

(11) **EP 3 183 758 B1**
(45) Veröffentlichungstag und Bekanntmachung des Hinweises auf die Patenterteilung: **30.10.2019**
(21) Anmeldenummer: 15750438.2
(22) Anmeldetag: 17.08.2015
(51) Int. Cl.: H01L 51/30, H01L 51/54, H01L 51/46

(54) **ORGANISCH ELEKTRONISCHES BAUTEIL MIT EINER VERNETZTEN ORGANISCH-ELEKTRONISCHEN FUNKTIONSSCHICHT UND ZUR HERSTELLUNG DIESES BAUTEILS VERWENDBARER ALKINYLETHER**
ORGANIC ELECTRONIC COMPONENT HAVING A CROSS-LINKED ORGANIC-ELECTRONIC FUNCTIONAL LAYER AND ALKINYLETHER USABLE FOR PRODUCTION OF SAID COMPONENT
COMPOSANT ORGANO-ÉLECTRONIQUE CONTENANT UNE COUCHE FONCTIONNELLE ORGANO-ÉLECTRONIQUE RÉTICULÉE ET ÉTHER D'ALCYNYLE POUVANT ÊTRE UTILISÉ DANS LA PRODUCTION DE CE COMPOSANT

(30) Priorität: 22.08.2014 DE 102014112038
(43) Veröffentlichungstag der Anmeldung: 28.06.2017
(73) Patentinhaber: Fraunhofer Gesellschaft zur Förderung der angewandten Forschung E.V., 80686 München (DE)
(72) Erfinder: LIMBERG, Felix, 10627 Berlin (DE); KRÜGER, Hartmut, 12489 Berlin (DE)
(86) Internationale Anmeldenummer: PCT/EP2015/068835
(87) Internationale Veröffentlichungsnummer: WO 2016/026806

(56) Entgegenhaltungen:
- EP-A1- 2 706 584
- JP-A- 2012 001 442
- OK SUK LEE ET AL: "Correlation between Functionality Preference of Ru Carbenes and exo / endo Product Selectivity for Clarifying the Mechanism of Ring-Closing Enyne Metathesis", THE JOURNAL OF ORGANIC CHEMISTRY, Bd. 78, Nr. 17, 14. August 2013 (2013-08-14), Seiten 8242-8249, XP055218611, US ISSN: 0022-3263, DOI: 10.1021/jo401420f
- ANNETTE D. ALLEN ET AL: "New Directions in Ketene Chemistry: The Land of Opportunity", EUROPEAN JOURNAL OF ORGANIC CHEMISTRY, Bd. 2012, Nr. 6, 11. Februar 2012 (2012-02-11), Seiten 1081-1096, XP055218585, DE ISSN: 1434-193X, DOI: 10.1002/ejoc.201101230
- Paul W Davies ET AL: "Synthetic Methods Intermolecular and Selective Synthesis of 2,4,5-Trisubstituted Oxazoles by a Gold-Catalyzed Formal [3 + 2] Cycloaddition**", Angewandte Chemie, vol. 123, no. 38, 26 July 2011 (2011-07-26), pages 9093-9097, XP055451318, DOI: 10.1002/ange.201103563

## Beschreibung

Die Anmeldung betrifft ein organisch-elektronisches Bauteil, insbesondere eine organische Leuchtdiode (OLED), eine organische photovoltaische Zelle (OPVC) oder einen organischen Feldeffekttransistor (OFET), das zumindest zwei Elektrodenschichten und eine dazwischen angeordnete organisch-elektronische Funktionsschicht enthält, wobei diese Funktionsschicht ein vernetztes Polymer umfasst.

Der Stand der Technik offenbart eine Vielzahl von Verfahren zur Aufbringung von organischen Funktionsschichten organisch-elektronischer Bauteile. Zum einen stehen Aufdampfverfahren zur Verfügung. Daneben kann aus Lösung prozessiert werden, insbesondere durch die Verwendung orthogonaler Lösemittel, welche nicht immer erfolgsversprechend anwendbar sind. Oft ist es von Vorteil, die strukturverwandten Komponenten dieser Bauteile aus ein und demselben Lösemittel zu prozessieren.

Um die Einschränkungen bei orthogonalen Lösungsmitteln zu umgehen, wurde vorgeschlagen, Funktionsschichten mit vernetzten Polymeren aufzubauen. Hier sind thermisch und photochemisch initiierbare Verfahren möglich.

Photochemisch können funktionelle Gruppen direkt aktiviert werden, beispielsweise Perfluorophenylazide. Allerdings muss hier hochenergetisches Licht auf die zu vernetzende Schicht gestrahlt werden, die entstehenden reaktiven Stickstoffspezies können in organisch-elektronische Komponenten insertieren und deren elektronische Eigenschaften verändern. Liaptis et. al. (Angew. Chem. 125, 9742) beschreibt die Verwendung von Photoinitiatoren, welche durch das eingestrahlte Licht aktiviert werden und die photoinsensible Reaktion initiieren. Hierbei kann beispielsweise eine Vernetzung von Oxetangruppen erfolgen. Allerdings verbleibt hierbei der Photoinitiator nach dem Aushärten in der Schicht und verschlechtert die Eigenschaften des Bauteils.

Ferner sind thermische Vernetzungsverfahren bekannt, mit denen Benzocylobuten (Cava et al., J. Am. Chem. Soc. 81, 4266 und Ma et al., Chem. Mater 19, 4827) bzw. Trifluorovinylether (Ji et al., Organometallics 17, 783) ohne das Zumischen weiterer Komponenten thermisch vernetzt werden. Allerdings verläuft die Vernetzung erst ab ca. 200 °C in ausreichender Geschwindigkeit. Bei derartigen Temperaturen ist aber im Regelfall von einer Degradation elektronisch aktiver Komponenten auszugehen und das Drucken auf flexiblen Polymersubstraten ist nicht möglich, da hier die Glastemperatur von üblich verwendeten Kunstoffen, wie z.B. PET, PEN, überschritten werden und diese ihre mechanischen Eigenschaften stark verändern.

Aizawa et al. beschreibt in Organic Electronics 14 (2013) 1614 die Herstellung von Funktionsschichten mittels thermischer Vernetzung von monomeren Verbindungen, die auf thermisch vernetzenden Styryleinheiten beruhen. Aufgrund der großen Reaktivität von Vinyl-Verbindungen ist das Einsatzspektrum der dort beschriebenen thermischen Vernetzung aber relativ begrenzt.

Die EP 2 706 584 offenbart organisch organisch-elektronische Bauteile und hierfür eingesetzte Ladungstransportmaterialien, die mittels einer Vernetzungsreaktion bei milden Bedingungen erhalten werden. Die Vernetzung erfolgt hierbei durch eine Cycloaddition eines Azids und eines Alkins, die jeweils in Polymeren oder in Vernetzungsreagentien enthalten sein können.

Lee et al. offenbart in Journal of Organic Chemistry 78 (2013) 8242 im Zusammenhang mit En-In-Metathese-Reaktionen die Herstellung substituierter Alkinylethylether.

Davies et al. offenbart in Angew. Chem. 123 (2011) 9093 u.a. Ethinylethylether der Formel EtO-C≡C-Ph bzw. EtO-C≡C-CH₂-CH=CH-Ph.

Die JP 2012 001442 A offenbart subsituierte Benzothienobenzothiophenderivate, die u.a. zweifach Alkinylether-Gruppen substituiert sind.

Aufgabe der vorliegenden Erfindung ist es, die Nachteile des Standes der Technik zu überwinden und insbesondere ein verbessertes Verfahren zum Aufbringen organischer Funktionsschichten in organisch-elektronischen Bauteilen mittels thermischer Vernetzung anzugeben. Eine weitere Aufgabe ist es, ein verbessertes Verfahren zur thermischen Vernetzung derartiger Schichten bei einer Temperatur von weniger als 200 °C zur Verfügung zu stellen.

Zumindest eine dieser Aufgaben wird durch den Gegenstand der unabhängigen Ansprüche gelöst. Unteransprüche und die Beschreibung lehren vorteilhafte Weiterbildungen.

Erfindungsgemäß wird ein organisch-elektronisches Bauteil vorgeschlagen, das organisch-elektronische Funktionsschichten mit einem vernetzten Polymer enthält, die zwischen einer ersten und einer zweiten Elektrodenschicht und einem Substrat angeordnet sind. Das vernetzte Polymer enthält substituierte 3-Alkoxycyclobut-2-en-1-on-Gruppen.

Dieses vernetzte Polymer kann hergestellt werden, indem zu vernetzenden Polymere und/oder Monomere durch eine bereitgestellte Vernetzerkomponente chemisch vernetzt werden, wobei die Vernetzerkomponente als Precursoreinheit Alkinylether enthält. Die Vernetzung erfolgt mittels einer Thermolyse bei einer Temperatur oberhalb von 100 °C, wobei aus dem Alkinylether thermisch eine Keten-Einheit gebildet wird, die mit dem zu vernetzenden Polymer reagiert.

Unter einer organisch-elektronischen Funktionsschicht wird anmeldungsgemäß insbesondere eine organische Schicht verstanden, die elektronen-leitende, elektronenblockierende, loch-leitende, loch-blockierende, strahlungsemittierende, strahlungsabsorbierende und/oder halbleitende Eigenschaften aufweist.

Dass eine erste Schicht "auf" einer zweiten Schicht oder "zwischen" zwei weiteren Schichten angeordnet ist, kann erfindungsgemäß bedeuten, dass die erste Schicht unmittelbar in direktem mechanischen und/oder elektrischen Kontakt auf der zweiten Schicht oder zwischen den zwei weiteren Schichten angeordnet ist. Weiterhin kann auch ein mittelbarer Kontakt bezeichnet sein, bei dem weitere Schichten zwischen der ersten Schicht und der zweiten Schicht oder zwischen der ersten Schicht und zumindest einer der zwei weiteren Schichten angeordnet sind.

Unter einer Precursoreinheit wird anmeldungsgemäß ein Alkinylether verstanden, der bei Temperaturen über 100 °C in ein Keten umwandelbar ist. Die Precursor-Einheit kann dabei in dem zu vernetzenden Polymer und/oder Monomer enthalten sein; sie kann aber auch in einem separaten Molekül vorliegen, das -nachdem die Ketenform generiert wurde - mit dem zu vernetzenden Polymer und/oder Monomer reagieren kann (beispielsweise mit nucleophilen Gruppen in dem zu vernetzenden Polymer und/oder Monomer).

Ohne hierauf beschränkt werden zu wollen, wird für den zugrundeliegenden Mechanismus Folgendes angenommen: Die Thermolyse von Alkinylethern führt unter Abspaltung von Teilen der Verbindung zu Ketenen welche anschließend in einer Vernetzungsreaktion mit Alkinylethern reagieren. Im Regelfall wird hierbei eine [2+2]-Cycloaddition (CA) erfolgen, so dass zumindest intermediär, im Regelfall aber als Endprodukt, Cyclobutenonderivate erhalten werden.

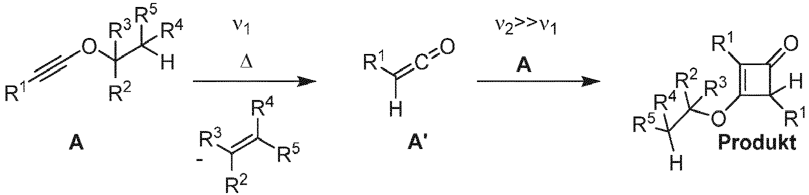

Thermisch induziert wird in einem sechsgliedrigen Übergangszustand, das dem Sauerstoff im Sechsring gegenüberstehende Proton umgelagert und ein Alken abgespalten. Das entstandene Keten, welches hier als reaktive Spezies bezeichnet wird, zyklisiert mit der Ausgangsverbindung zu dem Produkt: Das entstandene Cyclobutenonderivat hat keinen negativen Einfluss auf die Bauelemente.

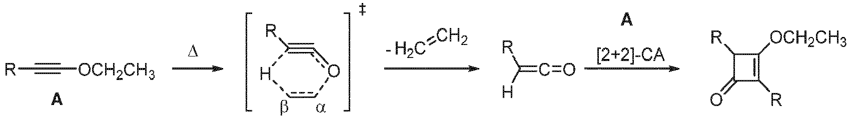

Die [2+2]-CA verläuft dabei im Regelfall weitaus schneller als die Thermolyse. Dadurch ist gewährleistet, dass entstandene reaktive Gruppen sofort weiterreagieren und es somit zu einem quantitativen Reaktionsverlauf kommt.

Die vorstehend erläuterte Reaktion macht sich die Erkenntnis zu Nutze, dass durch die Thermolyse aus einer elektronenreichen Verbindung eine elektronenarme Verbindung gebildet wird, die ihrerseits mit der elektronenreichen Ausgangsverbindung reagieren kann. Es versteht sich von selbst, dass beim Vorhandensein hiermit vergleichbarer anderer elektronenreicher Verbindungen im zu vernetzenden Polymer und/oder Monomer auch diese anderen Verbindungen (beispielsweise Alkine, die keine Alkinylether sind, oder Alkene) mit dem elektronenarmen Keten reagieren können.

Als Precursoreinheit eignen sich insbesondere Ethinylether, da diese bei Standardbedingungen eine hohe Stabilität aufweisen und sich spätestens ab einer Temperatur von 120 °C, häufig aber auch schon bei einer Temperatur unter 100 °C thermisch, auch ohne das Vorhandensein von Katalysatoren bzw. Initiatoren, in die Ketenform umlagern und damit eine Vernetzung ermöglichen. Ein höher substituiertes β-Kohlenstoffatom (vergleiche vorstehende Reaktionsgleichung) stabilisiert auftretende positive Ladungen und erleichtert dadurch die Abstraktion des β-ständigen Wasserstoffs und erhöht die Reaktivität der vernetzenden Einheit. Somit lässt sich im Regelfall in folgender Reihe die Vernetzungstemperatur unter 120 °C senken: R^{4,5} = H > R⁴ = Alk, R⁵ = H > R⁴ = Alk, R⁵ = Alk, wobei die Absenkung bei den zuerst genannten Substituenten am schwächsten ist und dann zunehmend größer wird und Alk für einen beliebigen Alkylrest steht.

Die erfindungsgemäß erhaltenen Schichten mit dem vernetzten Polymer sind gegenüber organischen Lösemitteln beständig und gewährleisten somit das Aufbringen weiterer Schichten ohne Beeinträchtigung der vernetzten Schicht. Unter "gegenüber organischen Lösemitteln beständig" wird erfindungsgemäß verstanden, dass die vernetzte Schicht durch Kontaktierung mit organischen Lösungsmitteln nicht oder zumindest in für die Prozessierung organisch-elektronischer Schichten typischen Verarbeitungszeiträumen nicht abgetragen wird. Insbesondere wird hierunter verstanden, dass die vernetzte Schicht von zumindest einem, bevorzugt mehr als drei und besonders bevorzugt allen der nachfolgend genannten Lösungsmittel:
1,2-Dichlorbenzol, Tetrahydronaphthalin, Chlorbenzol, 1,2-Dichlorbenzol, Chloroform, Toluol, THF, Tetrahydronaphthalin, Methoxypropylacetat
nicht oder zumindest nicht in für die Prozessierung organisch-elektronischer Schichten typischen Verarbeitungszeiträumen (und hier wiederum insbesondere für die erfindungsgemäß prozessierten vernetzten organisch-elektronischen Funktionsschichten) abgetragen wird. Die Bestimmung des Abtrags erfolgt über die Bestimmung der UV-Absorption und den Vergleich der Absorptionsbanden vor und nach dem Überspülen.

Mit dem in der Erfindung beschriebenen Verfahren können somit beliebige organisch elektronische Funktionsschichten erhalten werden. Zu nennen sind neben den generell einsetzbaren elektronen-leitenden, elektronen-blockierenden, loch-leitenden und lochblockierenden Schichten für die Anwendung in OLEDs insbesondere strahlungsemittierende Schichten, für die Anwendung in OPVCs insbesondere Absorber- oder Akzeptorschichten und für die Anwendung in OFETs Halbleiterschichten. Insbesondere die vorstehend genannten strahlungsemittierenden, strahlungsabsorbierenden oder halbleitenden organisch-elektronische Funktionsschichten können dabei aus einer polymeren Matrix, die wie vorstehend beschrieben vernetzt wurde, und zumindest einer emittierenden oder absorbierenden oder halbleitenden Komponente aufgebaut sein, wobei letztere in das Netzwerk chemisch eingebunden sein oder unvernetzt im Netzwerk vorliegen kann.

Ein wesentlicher Vorteil der Erfindung ist, dass die Vernetzung ohne das Zumischen von Photoinitiatoren oder hochenergetischer Bestrahlung auskommt, da hier die Reaktion thermisch initiiert wird. Die Reaktionsprodukte von Photoinitiatoren können allerdings dennoch in der vernetzten Funktionsschicht vorhanden sein, beispielsweise aufgrund vorausgegangener Polymerisationen zur Herstellung des erfindungsgemäß eingesetzten zu vernetzenden Polymers. Häufig wird in den vernetzten Funktionsschichten allerdings kein derartiges Reaktionsprodukt und auch kein Photoinitiator enthalten sein, da mit dem erfindungsgemäß beschriebenen Verfahren hierauf gerade verzichtet werden kann. Insbesondere ist dies der Fall, wenn die vernetzte Funktionsschicht direktaus zu vernetzenden Monomeren gebildet wurde.

Ein weiterer Vorteil ist, dass der Temperaturbereich der Vernetzungsreaktion so angepasst werden kann, dass er einerseits die Lagerstabilität der vernetzbaren Komponenten mit der Precursor-Einheit bei Raumtemperatur gewährleistet und andererseits eine effiziente und möglichst vollständige Vernetzung in der Schicht bei moderaten Temperaturen erlaubt. Zusätzlich können an den chemischen Verbindungen mit der Precursor-Einheit - im Gegensatz zu den hieraus gebildeten Ketenen- bei milden Reaktionsbedingungen im Regelfall vielfältige chemische Modifikationen erfolgen, insbesondere Derivatisierungen wie nucleophile Substitutionen, Veresterungen, Veretherungen und Polymerisationen.

Ein weiterer Vorteil des beschriebenen Verfahrens ist, dass es gegenüber Gasphasenabscheidung und der Verwendung orthogonaler Lösungsmittel deutlich kostengünstiger ist.

Wird als Precursor-Einheit in der Vernetzereinheit ein Alkinylether eingesetzt, so ist der weitestgehend chemisch inerte Charakter der Dreifachbindung von großem Vorteil. Er macht die Precursor-Einheit unempfindlich gegenüber vielen gängig angewandten Reaktionen, wie zum Beispiel radikalischen, anionischen oder kationischen Polymerisationen und Reaktionen, bei denen starke Basen (z.B.: n-Butyllithium) oder Nucleophile eingesetzt werden und erlaubt somit - anders als die im Stand der Technik genannte thermische Polymerisation - die Anwendbarkeit in einem großen Spektrum chemischer Reaktionssequenzen. Die Precursor-Einheit kann dabei problemlos in die verwendeten Polymersysteme, kleine Moleküle oder Blends etc. eingebunden werden. Zusätzlich ist bei Verwendung von Alkinylethern die Vernetzerkomponente gegenüber UV-Strahlung beständig. Bei den gängigen Alkinylethern ist bei Raumtemperatur keine Zersetzung der Precursor-Einheit über einen Zeitraum von mehreren Monaten zu verzeichnen und bei 50 °C in Lösung ist nach drei Tagen kein Zerfall nachweisbar. Mit den Alkinylethern werden vernetzbare Strukturen eingesetzt, die vorgelagerte chemische Verfahren zur Herstellung der Polymere nicht beeinflussen, und sich während dieser Verfahren im Wesentlichen inert verhalten. Sie können beispielsweise auch in Monomeren enthalten sein, die einer radikalischen Polymerisation zur Herstellung eines polymeren Precursors für die vernetzten Polymere der organischen Funktionsschichten unterworfen werden. Im Unterschied hierzu würden beispielsweise Styrylmonomere bereits im ersten Polymerisationsschritt zu einer unerwünschten Vernetzung führen.

Gemäß einer Ausführungsform wird Schritt B) in einem Temperaturfenster von 100 bis 200 °C, insbesondere 120 bis 180 °C, häufig 140 bis 160 °C durchgeführt. Im Regelfall sollten die organischen Funktionsschichten in elektronischen Bauteilen eine Glastemperatur von 110 °C nicht wesentlich unterschreiten, da der für den Betrieb der Bauteile gegebene Temperaturbereich keine Morphologieänderungen im Material zulassen sollte. Die Vernetzungsreaktion sollte jedoch im Regelfall oberhalb der Glastemperatur der Komponenten liegen, um vollständige Vernetzung durch hinreichende Eduktbeweglichkeit zu gewährleisten. Temperaturen die deutlich über 180 °C liegen, häufig auch schon Temperaturen über 160 °C, machen im Regelfall zum einen das Bedrucken auf gängige Kunststoffträgermaterialien unmöglich; zum anderen degradieren eine ganze Reihe üblicherweise in organische-elektronischen Bauelementen eingesetzte Materialien bei Temperaturen oberhalb 160 °C.

Gemäß einer weiteren Ausführungsform wird Schritt B), insbesondere in einem Temperaturbereich von 120 °C bis 180 °C innerhalb einer Reaktionszeit von wenigen Minuten bis wenigen Stunden, beispielsweise in einer Zeit von 3 Minuten bis 3 Stunden durchgeführt. In diesem Zeitfenster kann im Regelfall eine lösungsmittelbeständige Schicht erhalten werden.

Gemäß einer weiteren Ausführungsform wird zur Herstellung der erfindungsgemäßen organisch-elektronischen Bauteile nicht ausschließlich das vorstehend beschriebene Verfahren zur Herstellung aller vernetzter organisch-elektronischer Funktionsschichten eingesetzt; es wird dann zumindest die erste organisch-elektronische Funktionsschichte mit dem vorstehend beschriebenen Verfahren hergestellt und zumindest eine weitere organisch-elektronische Funktionsschicht mit einem anderen Verfahren. Insbesondere sind hierbei Bauteile zu nennen, bei denen die zweite Elektrodenschicht und das Substrat auf gegenüberliegenden Seiten der zumindest einen ersten organisch-elektronischen Funktionsschicht angeordnet sind und bei denen zwischen der organisch-elektronischen Funktionsschicht und der zweiten Elektrodenschicht die zumindest eine weitere organisch-elektronische Funktionsschicht angeordnet ist Hierbei kann zumindest eine weitere organisch-elektronische Funktionsschichtmittels Gasphasenabscheidung und/oder aus Lösung, beispielsweise unter Verwendung von orthogonalen Lösungsmitteln, mit Siebdruck oder mittels Aufrakeln erfolgen. Aus ökonomischen Gründen ist die Erzeugung möglichst vieler Schichten durch die erfindungsgemäße, vorstehend beschriebene thermische Vernetzung sinnvoll. Besonders zu erwähnen ist hierbei, dass für das Aufbringen der organisch-elektronischen Funktionsschicht, die als letzte vor der zweiten Elektrodenschicht aufgebracht wird das Problem entfällt, dass beim Aufbringen einer nachfolgenden organisch-elektronischen Funktionsschicht ein Lösungsmittel verwendet wird, das diese Schicht schädigen könnte. Daher kann diese organisch-elektronischen Funktionsschicht und der zweiten Elektrodenschicht ohne Vernetzung aus Lösung oder mittels Aufdampfen erzeugt werden, da keine Lösungsmittelbeständigkeit erforderlich ist.

Gemäß einer weiteren Ausführungsform der Erfindung werden in Schritt A) Polymere eingesetzt, die eine Precursor-Einheit als Vernetzerkomponente tragen, die erhältlich sind mittels Copolymerisation von Monomeren, die die Precursoreinheit enthalten, und Monomeren, die diese nicht enthalten. Als Monomere, die die Precursor-Einheit nicht enthalten, sind hierbei insbesondere Monomere zu nennen, die Substituenten tragen, die für die elektronischen Eigenschaften der organisch-elektronischen Funktionsschicht essentiell sind. Als Monomere sind hierbei insbesondere Vinylverbindungen, beispielsweise Vinylether und/oder Styrolderivate, zu nennen.

Lösungsmittelbeständige Schichten können erfindungsgemäß grundsätzlich auf zwei verschiedenen Wegen erreicht werden. Eine Lösemittelbeständigkeit ist insbesondere gegeben, wenn ein dreidimensionales (kovalentes) Netzwerk entsteht. Daneben ist auch die "Vernetzung" zu zweidimensional vernetzten unlöslichen Polymeren denkbar.

Ein dreidimensionales Netzwerk kann realisiert werden, wenn Monomere mit mindestens zwei Precursor-Einheiten funktionalisiert werden. Diese Moleküle bilden während der Vernetzung zuerst ein Polymer welches anschließend oder gleichzeitig mit einem Molekül mit drei Precursor-Einheiten dreidimensional vernetzt. Durch entsprechende Mischung von Molekülen mit zwei und drei Precursor-Einheiten und gegebenenfalls auch zusätzlich noch von Molekülen mit nur einer Precursor-Einheit kann dabei der Vernetzungsgrad gezielt maßgeschneidert werden.

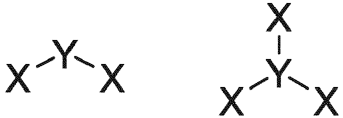

In der vorstehenden und den nachfolgenden Formeln steht X für beliebige Precursor-Einheiten, die gleich oder verschieden sein können und Y für eine beliebige Gruppe, über die diese Precursor-Einheiten chemisch miteinander verbunden sind. Ferner handelt es sich bei dem "Linker" Y um Substituenten bzw. Komponenten, die für die elektronischen Eigenschaften der organisch-elektronischen Funktionsschicht essentiell sind.

Alternativ kann ein dreidimensionales kovalentes Netzwerk realisiert werden, indem Seitengruppen an Polymeren mit einer oder mehreren Precursor-Einheiten X ausgestattet werden. Diese Polymere können anschließend untereinander Vernetzt werden.

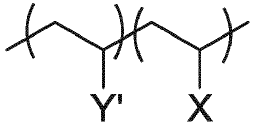

In der vorstehenden Formel steht Y' für eine beliebige funktionelle Gruppe, die -genau wie die vorstehend Gruppe Y - für die elektronischen Eigenschaften der organisch-elektronischen Funktionsschicht essentiell ist. Es versteht sich von selbst, dass die in die vorstehende Formel das System nur exemplarisch abbildet. Es kann selbstverständlich auch ein anderes Rückgrat als bei einer Poylvinylverbindung (Ethylen-Fragmente im Rückgrat) vorliegen, etwa ein Rückgrat aus Propylenfragmenten oder ein Rückgrat mit Sauerstoff-Atomen in der Kette (etwa bei Polyethylenglycolen). Daneben kann das Rückgrat, insbesondere an den schematisch dargestellten CH₂-Gruppen, neben X und Y' beliebige weitere Substituenten tragen.

Gemäß einer weiteren Alternative kann ein dreidimensionales kovalentes Netzwerk realisiert werden, indem Polymere an der Hauptkette mit einer oder mehreren Precursoreinheiten X ausgestattet werden, die über Y-Gruppen chemisch miteinander verbunden sind. Es entsteht also ein dreidimensional vernetztes Polymer, das die für die Funktion der Funktionsschicht verantwortliche Komponente in der Hauptgruppe des Polymers trägt.

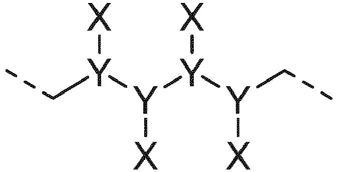

Ein zweidimensional vernetztes unlösliches Polymere kann erhalten werden, indem das zu vernetzende Polymer und/oder Monomer jeweils nur maximal zwei Precursor-Einheiten enthält, so dass nur eine lineare Kette bzw. Kettenverlängerung aufgebaut wird, wenn die Ketengruppe mit dem Precursor eines weiteren Polymers und/oder Monomers reagiert.

Wie sich aus den vorstehenden Ausführungen ergibt, kann eine beliebige Kombination verschiedener, mit der Precursor-Einheit funktionalisierter, Polymere (und hier wiederum mit Y bzw. Y' in der Hauptkette und/oder der Seitenkette) und/oder Monomeren und/ oder Polymerblends vernetzt werden. Ein Vorteil dieser Ausführungsform ist die hohe Kompatibilität der einzelnen Substanzklassen untereinander und eröffnet gegenüber dem Stand der Technik deutlich erhöhte Flexibilität im Aufbau der Funktionsschichten. So können beispielsweise auch Ausgangsmaterialien, die üblicherweise in organisch-elektronischen Funktionsschichten mit unterschiedlichen elektronischen Funktionen eingesetzt werden, in einem Polymer kombiniert werden (beispielsweise Lochtransportmaterialien, Emittermaterialien und Matrixmaterialien für die OLEDs). Des Weiteren können auch unterschiedliche vernetzende Polymere miteinander vernetzt werden.

Gemäß einer Ausführungsform liegt der Gehalt der Precursor-Einheit X bezogen auf die molare Gesamtmenge der vorstehend beschriebenen, für die organisch-elektronischen Eigenschaften ursächlichen Einheiten Y bzw. Y' und den Precursor-Einheiten X in dem zu vernetzenden Polymer zwischen 5 und 25 Mol%, bevorzugt zwischen 10 und 20 Mol%, noch bevorzugter bei 15 Mol%. Bei dieser Definition wird bezüglich der Komponenten Y und Y' auf die Darstellung und Definition in den vier vorstehenden chemischen Formeln Bezug genommen, in denen Y und Y' nicht nur für eine für die organisch-elektronischen Funktionen essentielle Gruppe steht sondern beispielsweise auch noch als Linker zwischen den Gruppen X fungiert.

Wie sich aus den vorstehenden Ausführungen ergibt, können Monomere mit ein, zwei, drei oder im Einzelfall auch mehr als drei Precursoreinheiten X ausgestattet werden. Diese können polymerisiert oder mit anderen mit Precursor-Einheiten funktionalisierten Monomeren und/oder Polymeren copolymerisiert werden.

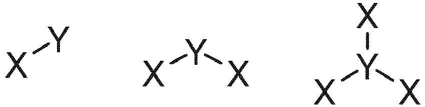

Als zu vernetzende Monomere und Polymere sind grundsätzlich alle in organisch elektronischen Funktionsschichten einsetzbaren, gegebenenfalls mit Precursor-Einheiten funktionalisierte, Materialien geeignet (es handelt sich hierbei um die vorstehend genannten Materialien, die für die organisch-elektronischen Eigenschaften essentiell sind). Zu nennen sind hier insbesondere Materialien für folgende Schichten: Elektronentransportschichten, Elektroneninjektionsschichten, Lochtransportschichten und/oder Lochinjektionsschichten. Solche Schichten können dazu dienen, die Effizienz der strahlungsemittierenden Vorrichtung weiter zu steigern und an einer oder mehreren geeigneten Stellen der strahlungsemittierenden Vorrichtung ausgebildet werden. Sie können geeignete Elektronentransportmaterialien und/oder Lochtransportmaterialien und/oder zur Verbesserung der Lochinjektion geeignete Materialien sowie Materialien zum Blockieren von Ladungsträgern umfassen.

Als Elektronentransportmaterialien seien beispielsweise Chinolinderivate, Bathocuproinderivate, Perylenderivate, Benzimidazolderivate, Oxadiazolderivate, Phenanthrolinderivate, Triazolderivate, Carbazolderivate, Bipyridinderivate und Pyrimidinderivate sowie Gemische der vorgenannten Stoffe genannt (wobei diese Stoffklassen auch Beispiele für die vorstehend definierten Gruppen Y und Y' sind). Für die Elektronentransportschicht (die zugleich als Loch-Blockierschicht dienen kann) werden bevorzugt Stoffe ausgewählt aus der Gruppe, bestehend aus CPB (4,4'-Bis(N-carbazolyl)-1,1'-biphenyl), TPBI (2,2',2"-(1,3,5-Benzintriyl)-tris(1-phenyl-1-H-benzimidazol)), AlQ₃(Tris-(8-hydroxyquinolin)aluminium), PBD (2-(4-Biphenylyl)-5-(4-tert-butylphenyl)-1,3,4-oxadiazol), spiro-PBD (Tris-(8-hydroxyquinoline)aluminium, (2,9-Dimethyl-4,7-diphenyl-1,10-phenanthrolin, 4,7-Diphenyl-1,10-phenanthrolin), 3,6-Bis (triphenylsilyl)carbazol und 3-(4-Biphenylyl)-4-phenyl-5-tert-butylphenyl-1,2,4-triazol sowie aus Gemischen dieser Stoffe, wobei diese Stoffe - sofern die Elektronentransport-Schicht mit dem erfindungsgemäßen Verfahren aufgebaut wird - insbesondere mit den Precursor-Einheiten subsituiert sein müssen oder mit einer Gruppe (beispielsweise einer Vinylgruppe) substituiert sein müssen, die mit den Vernetzerkomponenten (die beispielsweise ebenfalls eine Vinylgruppe tragen) copolymerisierbar sind. Diese Substitution kann - ausgehend von den entsprechenden Vorstufen - durch übliche aromatische Substitutionsreaktionen wie Grignard-Reaktionen, Suzuki-Kupplungen (oder allgemeiner durch Palladium-katalysierte Kreuzkupplungen), Wittig-Reaktionen oder Veresterung oder Veretherung der diesbezüglich einzusetzenden Hydroxy-Aromaten bzw. Hydroxy -Heteroaromaten. Die entsprechenden chemischen Reaktionen sind lange bekannt, der Fachmann - ein organischer Chemiker - weiß also, wie er für ein spezifisch genanntes Molekül eine derartige Substitution durchführen kann. Diese Substitutionsreaktionen sind auch für die in den nachfolgenden Absätzen beschriebenen Materialien anwendbar.

Lochtransportmaterialien oder Elektronen blockierende Materialien können insbesondere ausgewählt sein aus tertiären aromatischen oder heteroaromatischen Aminen, Fluorenderivaten, Carbazolderivaten, Polyanilin oder Polyethylendioxythiophen sowie Gemischen der vorgenannten Stoffe (wobei diese Stoffklassen auch Beispiele für die vorstehend definierten Gruppen Y und Y' sind). Als Lochtransport-Materialien werden bevorzugt Stoffe ausgewählt aus der Gruppe, bestehend aus MTDATA (4,4',4"-Tris(N-3-methylphenyl-N-phenylamino)triphenylamin), TCTA (Tris(4-carbazoyl-9-ylphenyl)amin), TAPC (Di-[4-(N,N-ditolyl-amino)-phenyl]cyclohexan), TPD (N,N'-Bis(3-methylphenyl)-N,N'-bis(phenyl)-benzidin), HMTPD (N,N,N',N' -Tetrakis-(3-methylphenyl)-3,3'-dimethylbenzidin), NPB (N,N'-Bis(naphth-1-yl)-N,N'-bis(phenyl)-benzidin), TNATA (4,4',4"-Tris[2-naphthyl(phenyl)amino]triphenylamin), Spiro-TAD (2,2',7,7'-Tetrakis(n,n-diphenylamino)-9,9'-spirobifluoren), PVK (Poly(9-vinylcarbazole) und CBP Poly(9-vinylcarbazole) sowie aus Gemischen dieser Stoffe, wobei diese Stoffe - sofern die Lochtransport-Schicht mit dem erfindungsgemäßen Verfahren aufgebaut wird - insbesondere mit den Precursor-Einheiten subsituiert sein müssen oder mit einer Gruppe (beispielsweise einer Vinylgruppe) substituiert sein müssen, die mit den Vernetzerkomponenten (die beispielsweise ebenfalls eine Vinylgruppe tragen) copolymerisierbar sind.

Für Lochinjektion geeignete Materialien können insbesondere ausgewählt sein aus Phthalocyaninen und Triarylaminderivaten, insbesondere Triphenylaminderivaten (wobei diese Stoffklassen auch Beispiele für die vorstehend definierten Gruppen Y und Y' sind),beispielsweise CuPC (Phthalocyanin, Kupferkomplex), TiOPC (Titanoxidphthalocyanin), m-MTDATA (4,4',4"-Tris[phenyl(m-tolyl)amino]triphenylamine), 2T-NATA (4,4',4"-Tris(N-(2-naphthyl)-N-phenyl-amino)triphenylamin), IT-NATA (4,4',4"-Tris(N-(1-naphthyl)-N-phenylamino)triphenylamin), NATA (4,4',4"-Tris(N,N-diphenylamino)triphenylamin) sowie Gemische der vorgenannten Stoffe, wobei die angegebenen Materialien optional dotiert sein können, und wobei diese Stoffe - sofern die Lochinjektions-Schicht mit dem erfindungsgemäßen Verfahren aufgebaut wird - insbesondere mit den Precursor-Einheiten subsituiert sein müssen oder mit einer Gruppe (beispielsweise einer Vinylgruppe) substituiert sein müssen, die mit den Vernetzerkomponenten (die beispielsweise ebenfalls eine Vinylgruppe tragen) copolymerisierbar sind.

Eine organische Emitterschicht kann als emittierendes Material eine organische oder organometallische Verbindung enthalten beziehungsweise daraus bestehen. Genannt seien insbesondere Derivate von Polyfluoren, Polythiophen und Polyphenylen (z.B. 2- oder 2,5-substituiertes Poly-p-phenylenvinylen) sowie Metallkomplexe, beispielsweise Iridium-, Platin- oder Kupfer-Komplexe wie blau phosphoreszierendes FlrPic (Bis(3,5-difluoro-2-(2-pyridyl)phenyl-(2-carboxypyridyl)-iridium III), grün phosphoreszierendes Ir(ppy)3(Tris(2-phenylpyridin)iridium(III)), rot phosphoreszierendes Ru(dtb-bpy)3^{∗}2(PF6) (Tris[4,4'-di-tert-butyl-(2,2')-bipyridin]ruthenium(III)komplex) sowie blau fluoreszierendes DPAVBi (4,4-Bis[4-(di-p-tolylamino)styryl]biphenyl), grün fluoreszierendes TTPA (9,10-Bis[N,N-di-(p-tolyl)-amino]anthracen) und rot fluoreszierendes DCM2 (4-(Dicyanomethylen)-2-methyl-6-julolidyl-9-enyl-4H-pyran) als nichtpolymere Emitter. Wenn die Emitterschicht nicht aus dem emittierenden Material besteht, liegt daneben noch ein Matrixmaterial vor. Hierfür geeignet sind insbesondere Quarterphenyle, Polaryle und die vorstehend definierten Stoffklassen der Lochtransport- und der Elektronentransportschicht, (wobei diese Stoffklassen auch Beispiele für die vorstehend definierten Gruppen Y und Y' sind), und wobei diese Stoffe - sofern die Emitter-Schicht mit dem erfindungsgemäßen Verfahren aufgebaut wird - insbesondere mit den Precursor-Einheiten subsituiert sein müssen oder mit einer Gruppe (beispielsweise einer Vinylgruppe) substituiert sein müssen, die mit den Vernetzerkomponenten (die beispielsweise ebenfalls eine Vinylgruppe tragen) copolymerisierbar sind.

Für den Einsatz in Absorberschichten und Akzeptorschichten in OPVCs sind beispielsweise Polythiophenderivate, PBDTBO-TPDO (Poly[(5,6-dihydro-5-octyl-4,6-dioxo-4H-thieno[3,4-C]pyrrole-1,3-diyl){4,8-bis[(2-butyloctyl)oxy]benzo[1,2-b:4,5-b']dithiophene-2,6-diyl}]), PBDTTT-CF (Poly[1-(6-{4,8-bis[(2-ethylhexyl)oxy]-6-methylbenzo[1,2-b:4,5-b']dithiophen-2-yl}-3-fluoro-4-methylthieno[3,4-b]thiophen-2-yl)-1-octanone]) zu nennen, wobei diese Stoffe - sofern die Absorberschicht oder Akzeptorschicht mit dem erfindungsgemäßen Verfahren aufgebaut wird - insbesondere mit den Precursor-Einheiten subsituiert sein müssen oder mit einer Gruppe (beispielsweise einer Vinylgruppe) substituiert sein müssen, die mit den Vernetzerkomponenten (die beispielsweise ebenfalls eine Vinylgruppe tragen) copolymerisierbar sind.

Für die Anwendung in organischen Feldeffekttransistoren können beispielsweise folgende Materialien für die Halbleiterschicht eingesetzt werden: BTBT(2,7-Diphenyl[1]benzothieno[3,2-b][1]benzothiophen), DNTT (Dinaphtho[2,3-b:2',3'-f]thieno[3,2-b]thiophen)., wobei diese Stoffe insbesondere mit den Precursor-Einheiten subsituiert sein müssen oder mit einer Gruppe (beispielsweise einer Vinylgruppe) substituiert sein müssen, die mit den Vernetzerkomponenten (die beispielsweise ebenfalls eine Vinylgruppe tragen) copolymerisierbar sind.

Die anmeldungsgemäße Aufgabe wird auch durch einen Alkinylether, der Formel R²R³CH-CR⁴R⁵-O-C≡C- R¹ gelöst. Hierin ist
R², R³, R⁴ und R⁵ jeweils unabhängig voneinander ausgewählt aus der Gruppe bestehend aus linearen, verzweigten oder zyklischen Alkyl-Resten, die substituiert oder unsubstituiert sein können und Wasserstoff und
R¹ entweder ein substituierter oder unsubstituierter Aryl oder Heteroaryl-Rest mit einem Molekulargewicht von 250 bis 2500 g/mol, bevorzugt von 400 bis 900 g/mol, wobei der Aryl- oder Heteroaryl-Rest ausgewählt ist aus Triarylaminen, Chinolinderivaten, Bathocuproinderivaten, Perylenderivaten, Benzimidazolderivaten, Oxadiazolderivaten, Phenanthrolinderivaten, Triazolderivaten, Carbazolderivaten, Bipyridinderivaten, Pyrimidinderivaten, Fluorenderivaten, Polyanilinen, Polyethylendioxythiophenen, Phthalocyaninen und aus Verbindungen, die zwei oder mehr der genannten Gruppen enthalten und insbesondere eine Gruppe ist, die für organisch-elektronische Eigenschaften eines Moleküls essentiell ist,
oder durch eine Gruppe -L-Z gebildet, in der L eine Einfachbindung, ein gegebenenfalls substituierter Alkylen-, Arylen- oder Heteroarylen-Linker ist und Z ein nicht vernetztes Polymer.

Durch die vorstehend definierte Verbindungsklasse lassen sich die vorteilhaften Eigenschaften der vernetzten organisch-elektronischen Schichten in besonderer Weise einstellen.

Gemäß einer weiteren Ausführungsform ist der Alkinylether ein Homopolymer oder ein Copolymer.

Gemäß einer Ausführungsform des nachfolgend beschriebenen organisch-elektronischen Polymers kann im Alkinylether R¹ auch ein gegebenenfalls substituierter Aryl- oder Heteroarylrest sein, der eine polymerisierbare Gruppe enthält, wobei die polymerisierbare Gruppe eine Vinylgruppe beziehungsweise das zu vernetzende Polymer ein durch eine Polymerisation von

Monomeren mit Vinylgruppen erhaltenes Polyvinyl ist. Mit derartigen Verbindungen wurden besonders gute Ergebnisse erzielt. Entsprechendes gilt für zu vernetzende Polymere, die durch Palladium-katalysierte Kreuzkupplungsreaktionen aufgebaut werden können, beispielsweise durch Suzuki-Kupplungen aus Ausgangsmaterialien mit Boronsäuregruppen und Ausgangsmaterialien mit Halogengruppen.

Gemäß einer weiteren Ausführungsform enthält der Alkinylether zwei, drei oder mehr Alkinylethergruppen der Formel R²R³CH-CR⁴R⁵-O-C≡C-R¹. Im Fall monomerer Verbindung kann über die Anzahl der enthaltenen Alkinylethergruppen pro Molekül der Vernetzungsgrad des vernetzen organisch-elektronischen Polymers in einfacher Weise gesteuert werden. Im Fall einer polymeren Verbindung gilt entsprechendes. Hier erfolgt die Steuerung allerdings über den Anteil der mittels Copolymerisation einpolymerisierten Precuror-Einheiten enthaltenden Gruppen.

Gemäß einer weiteren Ausführungsform ist im vorstehend definierten Alkinylether einer der Substituenten R³ oder R⁴ Wasserstoff, ein Aryl-Rest mit bis zu 12 Kohlenstoff-Atomen oder ein Alkyl-Rest, insbesondere Wasserstoff, Methyl, Ethyl, n-Propyl, i-Propyl, Phenyl oder t-Butyl und R², R⁵ und der andere der Substituenten R³ und R⁴ Wasserstoff. Mit den genannten flüchtigen Resten kann die Reaktivität der Bildung des Ketens zusätzlich reguliert werden. Zusätzlich kann häufig auch eine Regulierung darüber erfolgen, dass Reste gewählt werden, bei denen die Rückreaktion vom Keten zum Alkinylether nicht mehr möglich oder deutlich erschwert ist, beispielsweise bei aromatischen Subsitutenten.

Nachfolgend wird das anmeldungsgemäße vernetzte organisch-elektronische Polymer näher beschrieben. Dieses Polymer ist durch thermische Vernetzung eines Alkinylethers der Formel R²R³CH-CR⁴R5-O-C≡C-R¹ erhältlich.
Hierbei ist R², R³, R⁴ und R⁵ jeweils unabhängig voneinander ausgewählt aus der Gruppe bestehend aus linearen, verzweigten, zyklischen Alkyl-Resten oder aromatischen Resten, die substituiert oder unsubstituiert sein können und Wasserstoff.
R¹ ist entweder ein substituierter oder unsubstituierter Alkyl, Aryl oder Heteroaryl-Rest, der als polymerisierbare Gruppe eine Vinylgruppe ist enthält,
oder ein substituierter Aryl oder Heteroaryl-Rest mit einem Molekulargewicht von 250 bis 2500 g/mol, bevorzugt von 400 bis 900 g/mol, ist wobei der Aryl oder Heteroaryl-Rest zwei, drei oder mehr Alkinylethergruppen R²R³CH-CR⁴R⁵-O-C≡C- enthält, oder durch eine Gruppe -L-Z gebildet ist, in der L eine Einfachbindung, ein gegebenenfalls substituierter Alkylen-, Arylen- oder Heteroarylen-Linker ist und Z ein nicht vernetztes Polymer ist.
Die thermische Vernetzung erfolgt dabei - wie erläutert - durch Thermolyse des Alkinylethers in Gegenwart des Polymers und/oder Monomers bei einer Temperatur von mindestens 100 °C, wobei aus dem Alkinylether thermisch eine Keten-Einheit gebildet wird, die mit dem zu vernetzenden Polymer reagiert.

Wie bereits ausgeführt, enthält R¹ eine polymerisierbare Gruppe und ist dementsprechend eine monomere Verbindung oder ist eine polymere Verbindung, die durch eine Gruppe -L-Z gebildet ist. Hieraus lässt sich unter Anwendung von Standardpolymerisationsverfahren aus den Monomeren ein vernetzbares Polymer erhalten und aus dem vernetzbaren Polymer mittels der erfindungsgemäß beschriebenen Thermolyse und der nachfolgenden Vernetzungsreaktion das vernetzte organisch-elektronische Polymer.

Gemäß einer weiteren Ausführungsform enthält das vernetzte organisch-elektronische Polymer eine signifikante Menge Cyclobutenon-Gruppen, die durch die Reaktion des gebildeten Ketens mit Alkinylethern entstehen. Sie zeigen eine charakteristische Bande im IR-Spektrum bei 1750 cm⁻¹ auf. Mittels Vergleich von ¹³C-NMR-Spektroskopie und DEPT (Distortionless Enhancement by Polarization Transfer) Experimenten sollte der Kohlenstoff der Dreifachbindung neben dem Sauerstoff, durch Substitutionsgrad (quartäre Kohlenstoffe verschwinden im DEPT-Spektrum) und starker Tieffeldverschiebung (ca. 90 ppm) nachzuweisen sein.

Weitere Vorteile, vorteilhafte Ausführungsformen und Weiterbildungen der Erfindung ergeben sich aus den im Folgenden in Verbindung mit den Figuren und Beispielen beschriebenen Ausführungsformen.

### Ausführungsbeispiel 1:

### Organische Leuchtdiode (OLED)

Zumindest eine, mehrere oder auch alle der nachfolgend beschriebenen organisch-elektronischen Funktionsschichten können unter Verwendung der erfindungsgemäß beschriebenen Vernetzungsreaktion hergestellt sein.

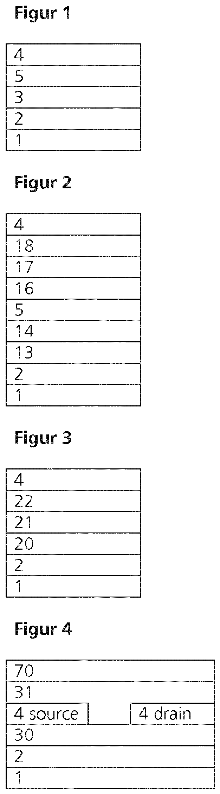

Figur 1 zeigt beispielhaft die Schichtenfolge einer OLED umfassend ein Substrat 1, darauf angeordnet eine erste Elektrode 2 und eine zweite Elektrode 4. Zwischen den beiden Elektroden liegen eine elektronenleitende Schicht 3, sowie die emittierende Schicht 5. Durch das Anlegen von Spannung an die Elektroden werden von einer der beiden Elektroden, der Kathode, Elektronen in die Schichten 3 und 5 injiziert und von der anderen Elektrode Löcher. Durch die Rekombination der Elektronen und Löcher können sich Excitonen bilden. In der in Figur 1 dargestellten Ausführungsform wird dann Strahlung aus der emittierenden Schicht 5 emittiert. In dieser befinden sich die emittierenden Materialien bzw. Substanzen, welche durch Excitonen zur Strahlungs-Emission angeregt werden können. Hierbei kann es sich beispielsweise um phosphoreszierende oder fluoreszierende Substanzen handeln.
Die elektronenleitende Schicht 3 kann hierbei jede Schicht sein, in der Elektronen transportiert werden. Vorzugsweise handelt es sich bei der elektronenleitenden Schicht gemäß der Erfindung um die lochblockierende Schicht 16, die Elektronentransportschicht 17 oder die Elektroneninjektionsschicht 18. Durch den verbesserten Elektronentransport können mehr Elektronen und Löcher rekombinieren, wodurch mehr Excitonen gebildet werden. Durch die gesteigerte Zahl an Excitonen wird die Emission und somit die Lichtausbeute erhöht.

Figur 2 zeigt eine weitere Ausführungsform eines Bauteils, welches als OLED ausgebildet ist. In der Abbildung ist eine schematische Seitenansicht eines Schichtstapels aus neun Schichten dargestellt. Dabei ist auf einem Substrat 1, das beispielsweise aus Glas ist, eine erste Elektrode 2, die beispielsweise transparent und aus ITO (Indium-Zinn-Oxid) ist angeordnet. Auf dieser Elektrode 2 ist eine Lochinjektionsschicht 13 angeordnet, auf der wiederum eine Lochtransportschicht 14 angeordnet ist. Auf der Lochtransportschicht 14 befindet sich eine organische aktive Schicht, die organische emittierende Schicht 5, auf der wiederum eine lochblockierende Schicht 16, auf die eine Elektronentransportschicht 17 folgt und auf dieser eine Elektroneninjektionsschicht 18 angeordnet sind. Auf der Elektroneninjektionsschicht 18 befindet sich eine zweite Elektrode 4, beispielsweise eine Metallelektrode. Beim Anlegen einer Spannung zwischen erster und zweiter Elektrode fließt Strom durch das Bauelement und in der emittierenden Schicht 5 wird Strahlung abgegeben, die beispielweise in Form von sichtbarem Licht beispielsweise über die erste Elektrodenschicht 2 und das Substrat 1 aus dem Bauelement ausgekoppelt werden kann. Alternativ kann auch zusätzlich oder alleine die zweite Elektrodenschicht 4 transparent ausgeformt sein und das Licht das Bauelement über beide Elektrodenschichten oder nur über die zweite Elektrodenschicht 4 verlassen.

### Ausführungsbeispiel 2:

### Organische photovoltaische Zelle (OPVC)

Zumindest eine, mehrere oder auch alle der nachfolgend beschriebenen organisch-elektronischen Funktionsschichten können unter Verwendung der erfindungsgemäß beschriebenen Vernetzungsreaktion hergestellt sein.

Organische Solarzellen bestehen ebenfalls aus einer Folge von organischen Funktionsschichten. Die elektrische Kontaktierung kann auch hier durch Metallschichten, transparente leitfähige Oxide und/oder transparente leitfähige Polymere erfolgen. Eine Solarzelle wandelt Lichtenergie in elektrische Energie um. Im Gegensatz zu anorganischen Solarzellen werden bei organischen Solarzellen durch das Licht nicht direkt freie Ladungsträger erzeugt, sondern es bilden sich zunächst Exzitonen, also elektrisch neutrale Anregungszustände. Erst in einem zweiten Schritt werden diese Exzitonen in freie Ladungsträger getrennt, die dann zum elektrischen Stromfluss beitragen.

Eine nach dem Stand der Technik bekannte Realisierungsmöglichkeit einer organischen Solarzelle besteht in einer pin-Diode mit folgendem Schichtaufbau (vergleiche Figur 3):
1 Träger, Substrat,
2 Grundkontakt, meist transparent,
20 p-Schicht (en), 21 i-Schicht (en), 22 n-Schicht (en),
4 Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht (en) bzw. p-Schicht (en) zumindest teilweise nominell undotiert sind und nur aufgrund der Materialeigenschaften, aufgrund unbekannter Verunreinigungen oder aufgrund von Einflüssen der Umgebung (z.B. angrenzende Schichten, Eindiffusion von Metallen oder anderen organischen Materialien, Gasdotierung aus der Umgebungsatmosphäre) n-leitende bzw. p- leitende Eigenschaften besitzen. In diesem Sinne sind derartigen Schichten primär als Ladungsträger-Transportschichten (also Elektronen- oder Lochtransportschichten) zu verstehen. Die Bezeichnung i-Schicht bezeichnet dagegen eine nominell undotierte Schicht (intrinsische Schicht). Eine oder mehrere i-Schichten können hierbei Schichten sowohl aus einem Material, als auch aus einer Mischung aus zwei Materialien bestehen.
Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In organischen Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i- Schichten liegen. Im eingebauten elektrischen Feld der Solarzelle werden die Elektronen nun zum n-Gebiet und die Löcher zum p-Gebiet abtransportiert.

### Ausführungsbeispiel 3:

### Organischer Feldeffekttransistor

Zumindest eine, mehrere oder auch alle der nachfolgend beschriebenen organisch-elektronischen Funktionsschichten können unter Verwendung der erfindungsgemäß beschriebenen Vernetzungsreaktion hergestellt sein.

Die Figur 4 zeigt eine schematische Ansicht eines Bauteils, welches als organischer Feldeffekttransistor (OFET) ausgebildet ist. Auf dem Substrat 1 ist die erste Elektrode 2 angeordnet, welche als Gate-Elektrodenschicht ausgeformt ist. Auf die erste Elektrode 2 folgt eine Isolatorschicht 30, welche beispielsweise ein Dielektrikum umfassen kann. Die zweite Elektrode 4 ist als Source-Drain-Kontaktschichten ausgeformt und umfasst eine elektronenleitende Schicht. Zwischen Source- und Drain-Kontaktschicht ist eine Halbleiterschicht 31 angeordnet, welche aus einem lochleitenden Material besteht. Der organische Feldeffekttransistor umfasst des Weiteren eine Deckschicht 70, die beispielsweise zur Verkapselung dienen kann.

### Ausführungsbeispiel 4:

### (poly-[N1-phenyl-N4-(4-(phenyl(m-tolyl)amino)phenyl)-N1-(m-tolyl)-N4-(4-vinylphenyl)benzol-1,4-diamin-ran-(1-((5-ethoxypent-4-yn-1-yl)oxy)-4-vinylbenzol)]):

### Beispiel 4a Synthese von 1-Ethoxy-5-iodopent-1-in

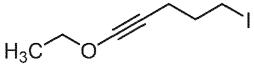

Zu einer auf 0 °C gekühlten Lösung aus Ethoxyacetylen (114 mmol in abs. Tetrahydrofuran (150 mL, c = 0,5 mol/L) wird n-Butyllithium (114 mmol) hinzugegeben und eine Stunde bei 0 °C gerührt. Dann wird vorab über Molsieb getrocknetes 1,3-Diiodpropan (114 mmol) zu der Reaktionsmischung gegeben und bei Raumtemperatur über Nacht gerührt. Dann wird das Lösemittel entfernt und mit Heptan als Eluent säulenchromatographisch getrennt. Das Produkt wird als farbloses Öl gewonnen (Ausbeute 30 %).

### Beispiel 4b Synthese von 1-((5-Ethoxypent-4-in-1-yl)oxy)-4-vinylbenzol

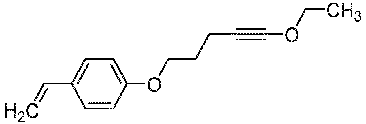

4-Acetoxystyrol (43 mmol) wird mit NaOH (500 mmol), Ethanol/Wasser (1:1)vermengt und für eine Stunde bei Raumtemperatur gerührt. Anschließend wird mit HCl neutralisiert, mit Toluol extrahiert und das Lösemittel entfernt. Das Produkt wird quantitativ als farbloser Feststoff erhalten.

4-Hydroxystyrol (6,2 mmol), Kaliumcarbonat (6,2 mmol), und 1-Ethoxy-5-lodopent-1-in (5,2 mmol) werden mit Dimethylformamid (c = 0,5 mol/L) 24 h bei 50 °C gerührt. Danach wird die Reaktionslösung mit Wasser versetzt und mit Ethylacetat extrahiert. Das Produkt (2,6 mmol; 0,6 g) wird nach Entfernung des Lösungsmittels mittels säulenchromatographischer Trennung, mit einem Gradienten aus n-Hexan und Ethylacetat, als farbloses Öl mit einer Ausbeute von 50 % gewonnen.

### Beispiel 4c Synthese von [N1-Phenyl-N4-(4-(phenyl(m-tolyl)amino)phenyl)-N1-(m-tolyl)-N4-(4-vinylphenyl)benzol-1,4-diamin-ran-(1-((5-ethoxypent-4-yn-1-yl)oxy)-4-vinylbenzol)]

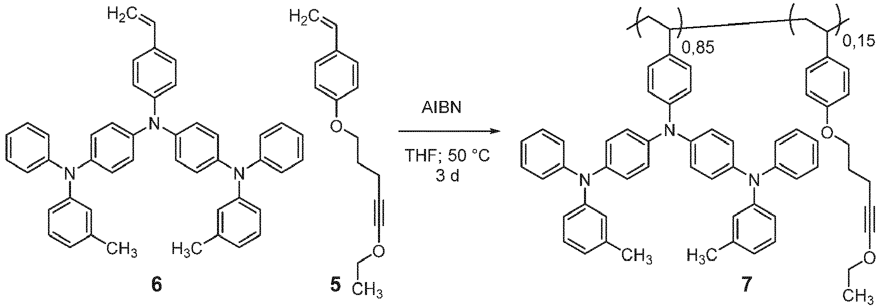

Das MTDATA Monomer 6 (1,58 mmol) wird zusammen mit dem Produkt aus Beispiel 4b (0,28 mmol) und AIBN (0,04 mmol) in frisch destilliertem Tetrahydrofuran (c = 10 mL/g) gelöst und für drei Tage in der Glovebox bei 50 °C gerührt. Die Reaktionslösung wird mit Tetrahydrofuran auf 20 mL verdünnt, drei Mal in n-Hexan/Etyhlacetat (4:1; 400 mL) gefällt und anschließend filtriert. Das Produkt (0,56 g) wird in Form eines weiß-gelben Pulvers mit einer Ausbeute von 54 % gewonnen.

### Ausführungsbeispiel 5:

### Poly[4-(3,6-dibutoxy-9H-carbazol-9-yl)-N-(4-(3,6-dibutoxy-9H-carbazol-9-yl)phenyl)-N-(4-vinylphenyl)anilin-ran-(1-((5-ethoxypent-4-in-1-yl)oxy)-4-vinylbenzol)] und Poly(4-(3,6-dibutoxy-9H-carbazol-9-yl)-N-(4-(3,6-dibutoxy-9H-carbazol-9-yl)phenyl)-N-(4-vinylphenyl)anilin)

### Beispiel 5a Synthese von 3,6-Dibutoxy-9H-Carbazol

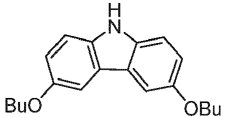

NaH (0,46 mol) wird in einem Kolben mit *abs.* Butanol (60 mL) versetzt. Falls das entstandene Natriumbutanolat nicht vollständig gelöst ist, wird so lange trockenes Dimethylformamid hinzugegeben, bis der Feststoff gelöst ist. Es wird gerührt, bis keine Gasentwicklung mehr zu verzeichnen ist. In einem weiteren trockenen und sauerstofffreien Kolben werden CuI (0,18 mol) und 2,6-Dibromo-9H-Carbazol (46 mmol;) vorgelegt und mit *abs.* Dimethylformamid (60 mL) versetzt. Anschließend wird das vorab hergestellte Natriumbutanolat zu der Reaktionslösung hinzugegeben und für 2 h bei 120 °C gerührt. Anschließend wird die Reaktionslösung auf Eiswasser gegeben und mit Toluol extrahiert. Nach Entfernen des Lösemittels wird in Methanol umkristallisiert. Das Produkt (40 mmol; 12 g) wird sauber in Form gelblicher Kristalle mit einer Ausbeute von 86 % gewonnen.

### Beispiel 5b Synthese von 4-(Bis(4-(3,6-Dibutoxy-9H-carbazol-9-yl)phenyl)amino)benzaldehyd

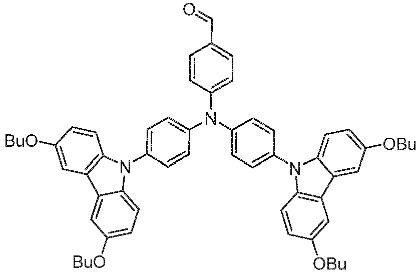

Vorab aktivierte Kupferbronze (25 mmol) wird zusammen mit 4-(bis(4-iodphenyl)amino)-Benzaldehyd (12 mmol), 3,6-Dibutoxy-9H -Carbazol (29 mmol), 18-Krone-6 (2,4 mmol) und Kaliumcarbonat (36 mmol) in einem Kolben vorgelegt. 1,2-Dichlorbenzol (30 mL) werden zu der Mischung hinzugegeben und es wird bei 200 °C für 24 h gerührt. Anschließend wird das Lösemittel entfernt und der verbliebene Rückstand in Toluol umkristallisiert. Das Produkt (10 mmol; 9,0 g) wird in Form hell -gelber Kristalle mit einer Ausbeute von 84 % gewonnen.

### Beispiel 5c Synthese von 4-(3,6-Dibutoxy-9H-Carbazol-9-yl)-N-(4-(3,6-Dibutoxy-9H-Carbazol-9-yl)phenyl)-N-(4-vinylphenyl)anilin

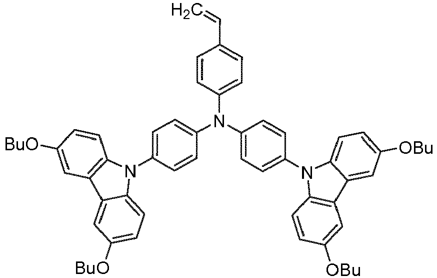

Kaliumtert-butanolat (23 mmol) wird zusammen mit Methyltriphenylphosphoniumbromid (24 mmol) unter Argonatmosphäre in Tetrahydrofuran *abs.* (150 mL) suspendiert und zwei Stunden bei 0 °C gerührt. Anschließend wird 4-(Bis(4- (3,6-dibutoxy-9H-carbazol -9-yl)phenyl)amino)benzaldehyd (7,9 mmol) in Tetrahydrofuran *abs.* (500 mL) gelöst und zu der Reaktionslösung gegeben und zwei Stunden bei 0 °C gerührt. Anschließend wird mit Brine (3x500 mL) gewaschen, die organische Phase reduziert und der verbliebene Feststoffmit Toluol als Eluent chromatographisch gereinigt. Das Produkt (5,3 mmol; 4,7 g) wird als weißer Feststoff mit einer Ausbeute von 67 % gewonnen.

### Beispiel 5d Synthese von Poly[4-(3,6-dibutoxy-9H-carbazol-9-yl)-N-(4-(3,6-dibutoxy-9H-carbazol-9-yl)phenyl)-N-(4-vinylphenyl)anilin-ran-(1-((5-ethoxypent-4-yn-1-yl)oxy)-4-vinylbenzol)]

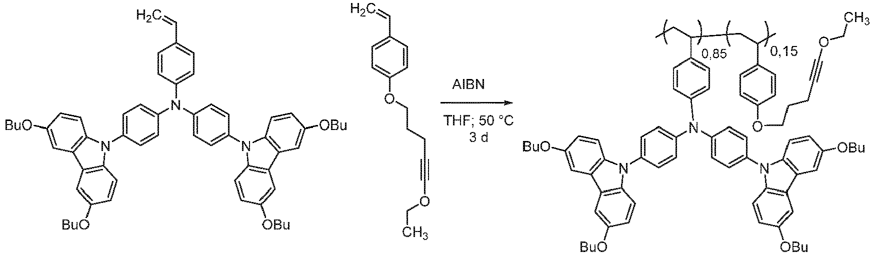

4-(3,6-Di butoxy-9H-Carbazol-9-yl)-N-(4-(3 , 6-Dibutoxy-9 H-C arbazol-9-yl)phenyl)-N-(4-vinylphenyl)anilin (1,58 mmol) wird zusammen mit 1-((5-ethoxypent-4-in-1- yl)oxy)-4-vinylbenzol (0,28 mmol) und Azoisobutyronitril (0,04 mmol) in *abs.* und frisch destilliertem Tetrahydrofuran (c = 10 mL/g) gelöst und für drei Tage in der Glovebox bei 50 °C gerührt. Die Reaktionslösung wird mit Tetrahydrofuran auf 20 mL verdünnt, drei Mal in *n*-Hexan/Etyhlacetat (4:1; 400 mL) gefällt und anschließend filtriert. Das Produkt (0,70 g) wird in Form eines weiß-gelben Pulvers mit einer Ausbeute von 50 % gewonnen.

### Beispiel 5e Synthese von Poly(4-(3,6-dibutoxy-9H-carbazol-9-yl)-N-(4-(3,6-dibutoxy-9H-carbazol-9-yl)phenyl)-N-(4-vinylphenyl)anilin)

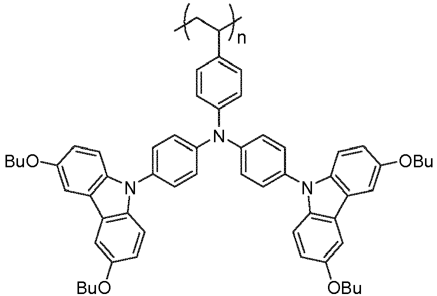

4-(3,6-Dibutoxy-9H-carbazol-9-yl)-N-(4-(3,6-Dibutoxy-9 H-Carbazol-9-yl)phenyl)-N-(4-vinylphenyl)anilin (1,12 mmol) wird zusammen mit Azoisobutyronitril (0,02 mmol) in abs. und frisch destilliertem Toluol (c = 10 mL/g) gelöst und für drei Tage in der Glovebox bei 50 °C gerührt. Die Reaktionslösung wird mit Toluol auf 20 mL verdünnt, drei Mal in Methanol/Etyhlacetat (2:1; 400 mL) gefällt und anschließend filtriert. Das Produkt wird in Form eines weiß-gelben Pulvers mit einer Ausbeute von 64 % gewonnen.

### Ausführungsbeispiel 6:

### Synthese von Tris(4-(2-((5-Ethoxypent-4-yn-1-yl)oxy)-9H-carbazol-9-yl)phenyl)amin Beispiel 6a Synthese von 2-Methoxy-9H-carbazol

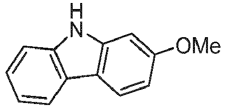

2-Hydroxy-9H-carbazol (23 mmol), Kaliumcarbonat (58 mmol) und Methyliodid werden unter Argonatmosphäre in Dimethylformamid (30 mL) gelöst und vier Stunden bei Raumtemperatur gerührt. Anschließend wird mit Ethylacetat (400 mL) verdünnt, der entstandene Feststoff abfiltriert und die Lösung mit Brine (3x100 mL) gewaschen, und das Lösemittel *in vacuo* entfernt. Der Rückstand wird mit CHCl₃ säulenchromatographisch getrennt. Das Produkt (15 mmol; 3,0 g) wird in Form als gelblicher Feststoff mit einer Ausbeute von 66 % gewonnen.

### Beispiel 6b Synthese von Tris(4-(2-Methoxy-9H-carbazol-9-yl)phenyl)amin

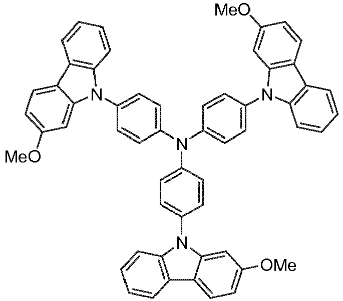

2-Methoxy-9H-carbazol (15 mmo), Tris(4-iodophenyl)amin (4,2 mmol), Kupferiodid (1,3 mmol), Kaliumcarbonat (15 mmol) und 1,10-Phenanthrolin (2,5 mmol) werden unter Argonatmosphäre in Dimethylformamid (26 mL) suspendiert und 22 Stunden bei 150 °C gerührt. Nach dem Abkühlen wird die Lösung auf Wasser (200 mL) gefällt und der ausgefallene Feststoff abfiltriert und mit reichlich Wasser gewaschen. Der Rückstand wird in Tetrahydrofuran gelöst und säulenchromatographisch mit einem Gradienten aus n-Hexan und Toluol als Eluent getrennt. Das Produkt (2,4 mmol; 2,0 g) wird als weiß-gelber Feststoff mit einer Ausbeute von 57 % gewonnen.

### Beispiel 6c Synthese von 9,9,9'-(Nitrilotris(benzene-4,1-diyl))tris(9H-carbazol-2-ol)

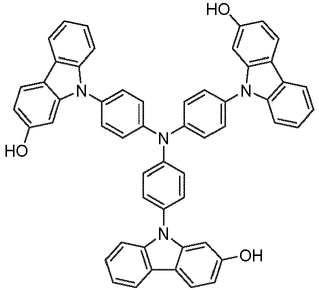

Tris(4-(2-Methoxy-9H-carbazol-9-yl)phenyl)amin (1,8 mmol) wird unter Argonatmosphäre in *abs.* Dichlormethan (20 mL) gelöst und auf 0 °C heruntergekühlt. Bortribromid (11 mmol) wird hinzugegeben und vier Stunden bei 0 °C gerührt. Überschüssiges Bortribromid wird mit Methanol ausgelöscht. Nach Entfernen des Lösungsmittels erfolgt eine säulenchromatographische Trennung mit einem Gradienten aus n-Hexan und Ethylacetat, die das Produkt (1,8 mmol; 1,5 g) als braunen Feststoff in quantitativer Ausbeute liefert.

### Beispiel 6d Synthese von Tris(4-(2-((5-Ethoxypent-4-yn-1-yl)oxy)-9H-carbazol-9-yl)phenyl)amin

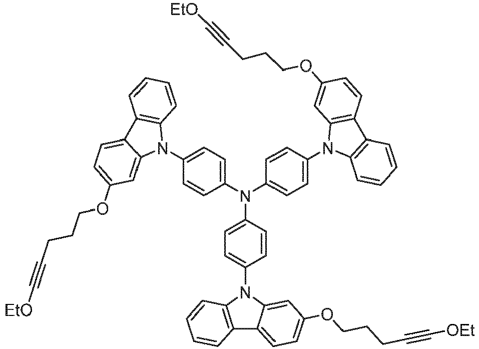

9,9',9"-(Nitrilotris(benzene-4,1-diyl))tris(9H-carbazol-2-ol) (1,8 mmol), 1-Ethoxy-5-Iodopent-1-in (7,2 mmol) und Kaliumcarbonat (7,2 mmol) werden unter Argonatmosphäre in *abs.* Dimethylformamid (20 mL) für vier Stunden bei 50 °C gerührt. Die Reaktionslösung wird mit Dichlormethan (100 mL) verdünnt und mit Brine (3x100 mL) gewaschen. Nach Entfernen des Lösemittels wird säulenchromatographisch mit einem Gradienten aus Heptan und Chloroform als Eluent getrennt. Das Produkt (1,0 mmol; 1,1 g) wird als gelber amorpher Feststoff mit einer Ausbeute von 55 % gewonnen.

### Ausführungsbeispiel 7:

### Poly(9,9-bis(6-(4-((5-ethoxypent-4-in-1-yl)oxy)phenoxy)hexyl)-9',9'-dihexyl-9H,9'H-2,2'-bifluoren)-polymeranaloge Synthese

### Beispiel 7a Synthese von 4-((5-Ethoxypent-4-in-1-yl)oxy)phenol

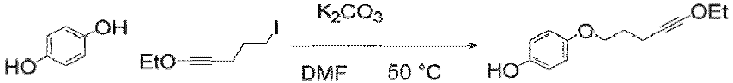

1-Ethoxy-5-iodpent-1-in (21,0 mmol), Hydrochinon (21,0 mmol) und Kaliumcarbonat (42 mmol) werden für 20 Stunden bei 50 °C in DMF gerührt. Anschließend wird mit Toluol verdünnt und mit Brine gewaschen. Säulenchromatographische Trennung mit einem Gradienten aus n-Heptan und Ethylacetat führt zum Produkt (45 % Ausbeute).

### Beispiel 7b Synthese von Poly(9,9-bis(6-bromhexyl)-9',9'-dihexyl-9H,9'H-2,2'-bifluoren)

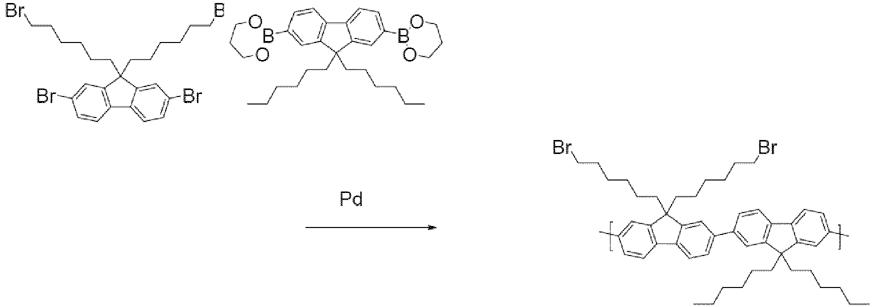

2,7-Dibrom-9,9-bis(6-bromhexyl)-9H-fluoren (0,755 mmol), 2,2'-(9,9-Dihexyl-9H-fluoren-2,7-diyl)bis(1,3,2-dioxaborinan) (0,755 mmol), Palladium(II)Acetat (0,87 mg) Natriumcarbonat (38,8 mmol) und Tri(o-tolyl)phosphin (7 mg) werden in einem Lösemittelgemisch aus THF und Wasser (1:1) für 24 h bei 80 °C gerührt. Das Polymer wird anschließend in Methanol demonomerisiert. Nach dem Trocknen wird das Polymer (73 % Ausbeute) als Feststoff erhalten.

### Beispiel 7c Synthese von Poly(9,9-bis(6-(4-((5-ethoxypent-4-in-1-yl)oxy)phenoxy)hexyl)-9',9'-dihexyl-9H,9'H-2,2'-bifluoren)

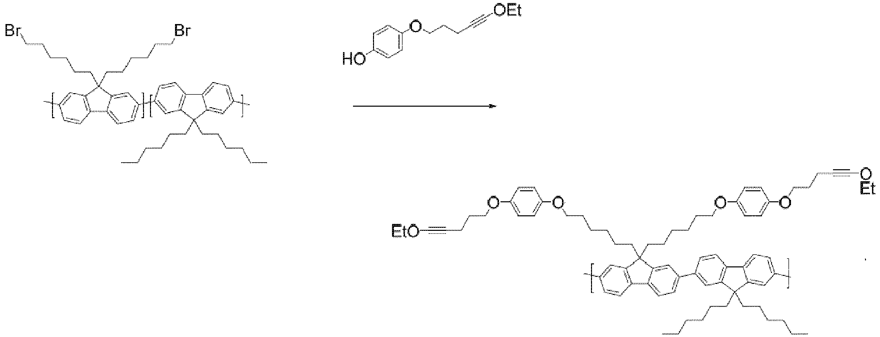

Das Polymer aus Beispiel 7b (0,5 g) und 4-((5-Ethoxypent-4-in-1-yl)oxy)phenol (10 Äquivalente bezogen auf Brom) und Kaliumcarbonat (10 Äquivalente bezogen auf Brom) werden in THF bei 50 °C für 24 h gerührt. Die Reaktionsmischung wird mit Wasser extrahiert und anschließend mittels Methanol demonomerisiert. Nach dem Trocknen wird das Polymer (98 % Ausbeute) als Feststoff erhalten.

### Ausführungsbeispiel 8:

### Poly(9,9-bis(6-(4-((5-ethoxypent-4-in-1-yl)oxy)phenoxy)hexyl)-9',9'-dihexyl-9H,9'H-2,2'-bifluoren) - aus nicht polymeren Vorstufen

### Beispiel 8a Synthese von Synthese von Poly(9,9-bis(6-(4-((5-ethoxypent-4-in-1-yl)oxy)phenoxy)hexyl)-9',9'-dihexyl-9H,9'H-2,2'-bifluoren)

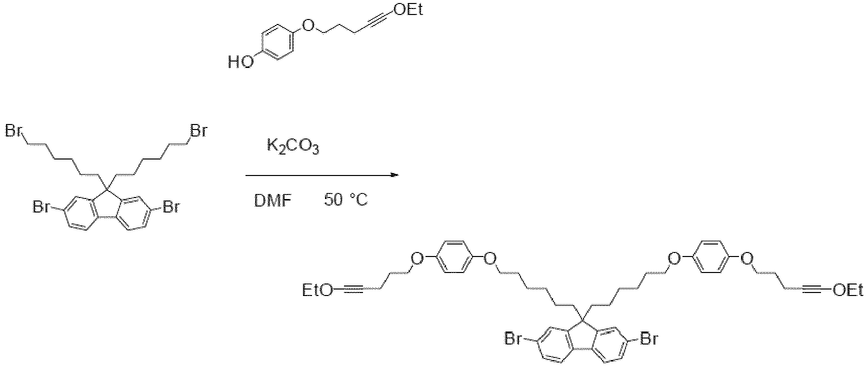

2,7-Dibrom-9,9-bis(6-bromhexyl)-9H-fluoren (1,55 mmol), 4-((5-ethoxypent-4-in-1-yl)oxy)phenol (siehe Beispiel 7a - 4,64 mmol) und Kaliumcarbonat (27,8 mmol) werden für 20 Stunden bei 50 °C in DMF gerührt. Anschließend wird mit Toluol verdünnt und mit Brine gewaschen. Säulenchromatographische Trennung mit einem Gradienten aus n-Heptan und Ethylacetat führt zum Produkt (75 % Ausbeute).

### Beispiel 8b Synthese von Poly(9,9-bis(6-(4-((5-ethoxypent-4-in-1-yl)oxy)phenoxy)hexyl)-9',9'-dihexyl-9H,9'H-2,2'-bifluoren)

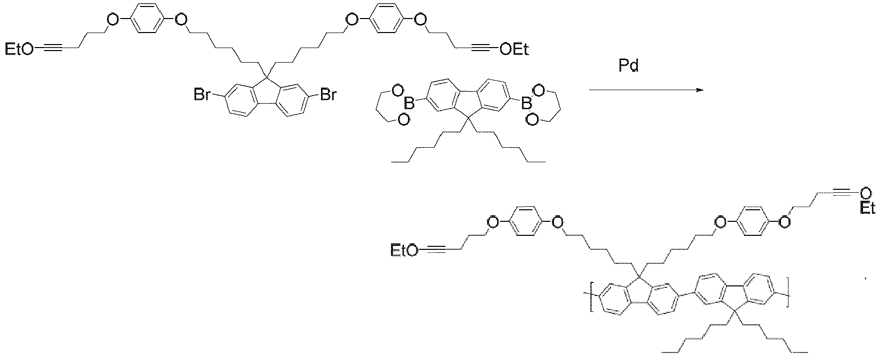

2,7-Dibrom-9,9-bis(6-(4-((5-ethoxypent-4-in-1-yl)oxy)phenoxy)hexyl)-9H-fluoren (0,755 mmol), 2,2'-(9,9-Dihexyl-9H-fluoren-2,7-diyl)bis(1,3,2-dioxaborinane) (0,755 mmol), Palladium(II)Acetat (0,87 mg) Natriumcarbonat (38,8 mmol) und Tri(o-tolyl)phosphin (7,00 mg) werden in einem Lösemittelgemisch aus THF und Wasser (1:1) für 24 h bei 80 °C gerührt. Das Polymer wird anschließend in Methanol demonomerisiert. Nach dem Trocknen wird das Polymer (78 % Ausbeute) als Feststoff erhalten.

### Ausführungsbeispiel 9:

### Poly(2-(2,5-bis((5-ethoxypent-4-in-1-yl)oxy)phenyl)-9,9-dihexyl-9H-fluoren) - polymeranaloge Synthese

### Beispiel 9a Synthese von 2-(9,9-Dihexyl-9H-fluoren-2-yl)benzol-1,4-diol

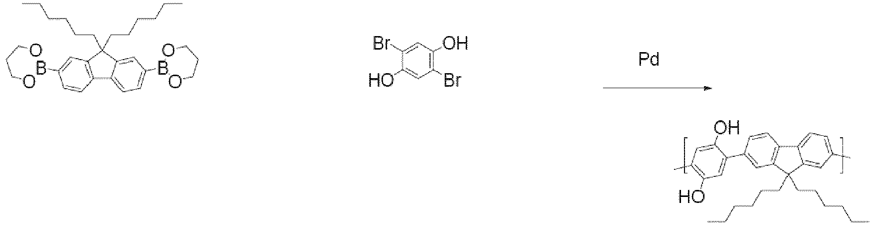

2,5-Dibromhydrochinon (0,755 mmol), 2,2'-(9,9-Dihexyl-9H-fluoren-2,7-diyl)bis(1,3,2-dioxaborinane) (0,755 mmol), Palladium(II)Acetat (0,87 mg) Natriumcarbonat (38,8 mmol) und Tri(o-tolyl)phosphin (7 mg) werden in einem Lösemittelgemisch aus THF und Wasser (1:1) für 24 h bei 80 °C gerührt. Das Polymer wird anschließend in Methanol demonomerisiert. Nach dem Trocknen wird das Polymer (60 % Ausbeute) als Feststoff erhalten.

### Beispiel 9b Synthese von Poly(2-(2,5-bis((5-ethoxypent-4-in-1-yl)oxy)phenyl)-9,9-dihexyl-9H-fluoren)

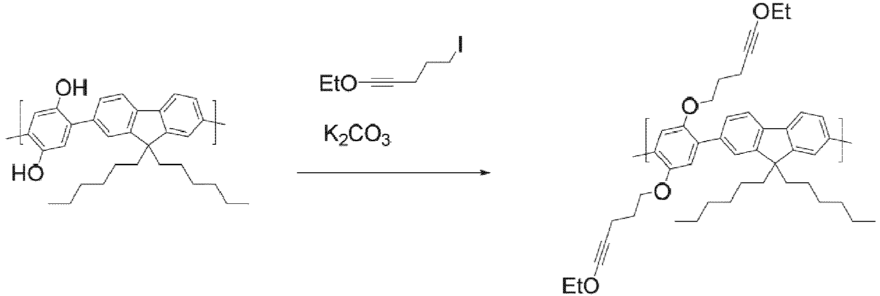

Das Polymer aus Beispiel 9a (0,5 g) und 4-((5-Ethoxypent-4-in-1-yl)oxy)phenol (10 Äquivalente bezogen auf die Hydroxygruppen) und Kaliumcarbonat (10 Äquivalente bezogen auf die Hydroxygruppen) werden zusammen in THF bei 50 °C für 24 h gerührt. Die Reaktionsmischung wird mit Wasser extrahiert und anschließend mittels Methanol demonomerisiert. Nach dem Trocknen wird das Polymer (92 % Ausbeute) als Feststoff erhalten.

### Ausführungsbeispiel 10:

### Poly(2-(2,5-bis((5-ethoxypent-4-in-1-yl)oxy)phenyl)-9,9-dihexyl-9H-fluoren) - aus nicht polymeren Vorstufen

### Beispiel 10a Synthese von 1,4-Dibrom-2,5-bis((5-ethoxypent-4-in-1-yl)oxy)benzol

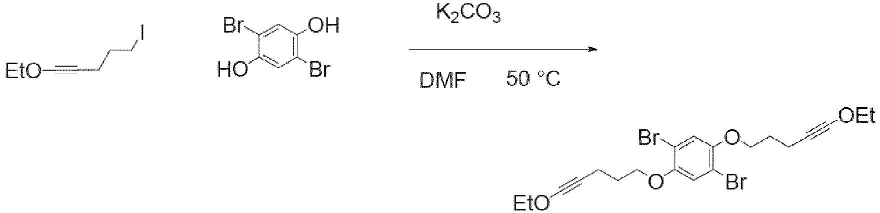

1-Ethoxy-5-iodpent-1-in (105 mmol), 2,5-Dibromhydrochinon (21,0 mmol) und Kaliumcarbonat (42 mmol) werden für 20 Stunden bei 50 °C in DMF gerührt. Anschließend wird mit Toluol verdünnt und mit Brine gewaschen. Säulenchromatographische Trennung mit einem Gradienten aus n-Heptan und Ethylacetat führt zum sauberen Produkt (85 % Ausbeute).

### Beispiel 10b Synthese von Poly(2-(2,5-bis((5-ethoxypent-4-in-1-yl)oxy)phenyl)-9,9-dihexyl-9H-fluoren)

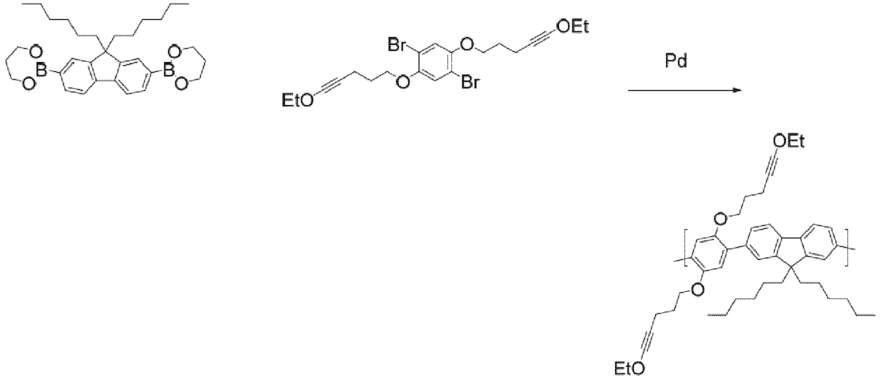

1,4-Dibromo-2,5-bis((5-ethoxypent-4-in-1-yl)oxy)benzol (0,755 mmol), 2,2'-(9,9-Dihexyl-9H-fluoren-2,7-diyl)bis(1,3,2-dioxaborinane) (0,755 mmol), Palladium(II)Acetat (0,87 mg) Natriumcarbonat (38,8 mmol) und Tri(o-tolyl)phosphin (7 mg) werden in einem Lösemittelgemisch aus THF und Wasser (1:1) für 24 h bei 80 °C gerührt. Das Polymer wird anschließend in Methanol demonomerisiert. Nach dem Trocknen wird das Polymer (55 % Ausbeute) als Feststoff erhalten.

### Ausführungsbeispiel 11:

### Poly(4-(9,9-dihexyl-9H-fluoren-2-yl)-N-(4-((5-ethoxypent-4-in-1-yl)oxy)phenyl)-N-phenylanilin)

### Beispiel 11a Synthese von 4-Brom-N-(4-bromphenyl)-N-(4-((5-ethoxypent-4-in-1-yl)oxy)phenyl)anilin

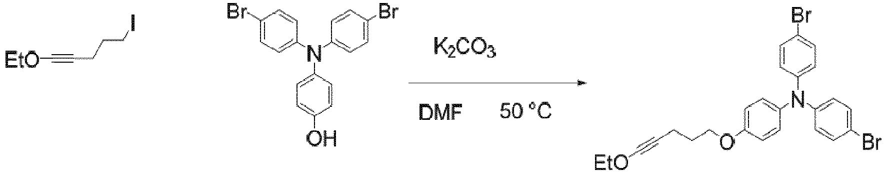

1-Ethoxy-5-iodpent-1-in (105 mmol), 4-(Bis(4-bromphenyl)amino)phenol (21,0 mmol) und Kaliumcarbonat (42 mmol) werden für 20 Stunden bei 50 °C in DMF gerührt. Anschließend wird mit Toluol verdünnt und mit Brine gewaschen. Säulenchromatographische Trennung mit einem Gradienten aus n-Heptan und Ethylacetat führt zum sauberen Produkt (82 % Ausbeute).

### Beispiel 11b Synthese von Poly(4-(9,9-dihexyl-9H-fluoren-2-yl)-N-(4-((5-ethoxypent-4-in-1-yl)oxy)phenyl)-N-phenylanilin)

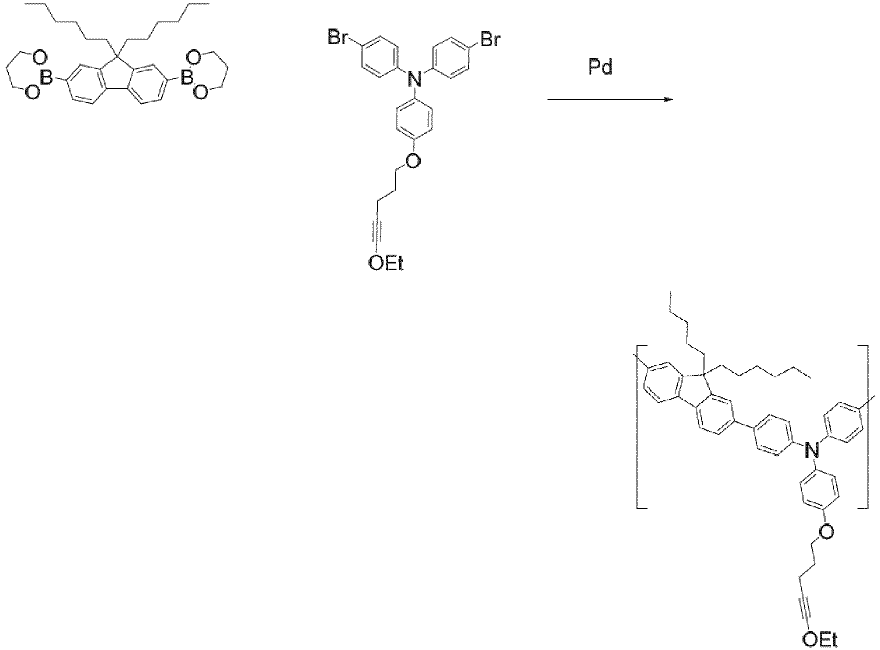

4-Brom-N-(4-bromphenyl)-N-(4-((5-ethoxypent-4-in-1-yl)oxy)phenyl)anilin (0,755 mmol), 2,2'-(9,9-Dihexyl-9H-fluoren-2,7-diyl)bis(1,3,2-dioxaborinane) (0,755 mmol), Palladium(II)Acetat (0,87 mg) Natriumcarbonat (38,8 mmol) und Tri(o-tolyl)phosphin (7 mg) werden in einem Lösemittelgemisch aus THF und Wasser (1:1) für 24 h bei 80 °C gerührt. Das Polymer wird anschließend in Methanol demonomerisiert. Nach dem Trocknen wird das Polymer (58 % Ausbeute) als Feststoff erhalten.

### Ausführungsbeispiel 12:

### Synthese von Tris[4-(6-ethoxyhex-5-in-1-yl)-2-phenylpyridinato-C2,N]iridium(III)

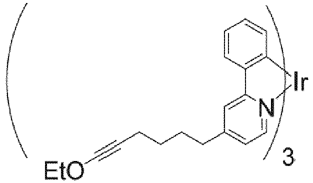

Zu einer Lösung von Tris[4-methyl-2-phenylpyridinato-C2,N]iridium(III) (0,765 mmol) in THF (700 mL) wird bei -78 °C Lithiumdiisopropylamid (0,2 M in THF; 7,65 mmol) zugegeben und eine Stunde bei dieser Temperatur gerührt. Anschließend wird eine Stunde bei Raumtemperatur gerührt und erneut auf -78 °C gekühlt. Danach wird 1-Ethoxy-5-iodopent-1-in (2 M in THF; 7,65 mmol) langsam zugegeben, erneut auf Raumtemperatur erwärmt und auf gesättigte Ammoniumchloridlösung gegeben. Es wird mit Dichlormethan extrahiert, mit Brine gewaschen und getrocknet. Nach säulenchromatographischer Trennung mit einem Gradienten aus n-Heptan und Dichlormethan wird das Produkt (20 % Ausbeute) als gelber Feststoff erhalten.

### Ausführungsbeispiel 13:

### Vernetzungsreaktion

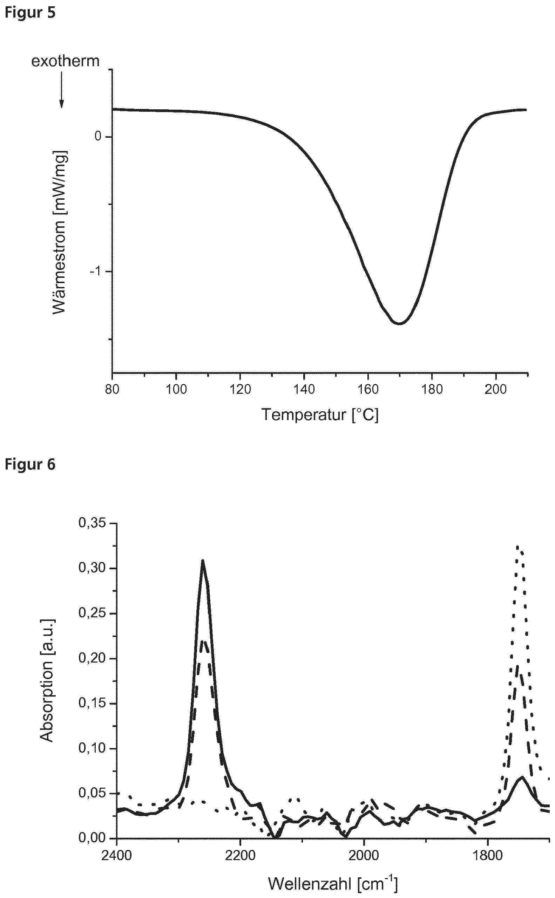

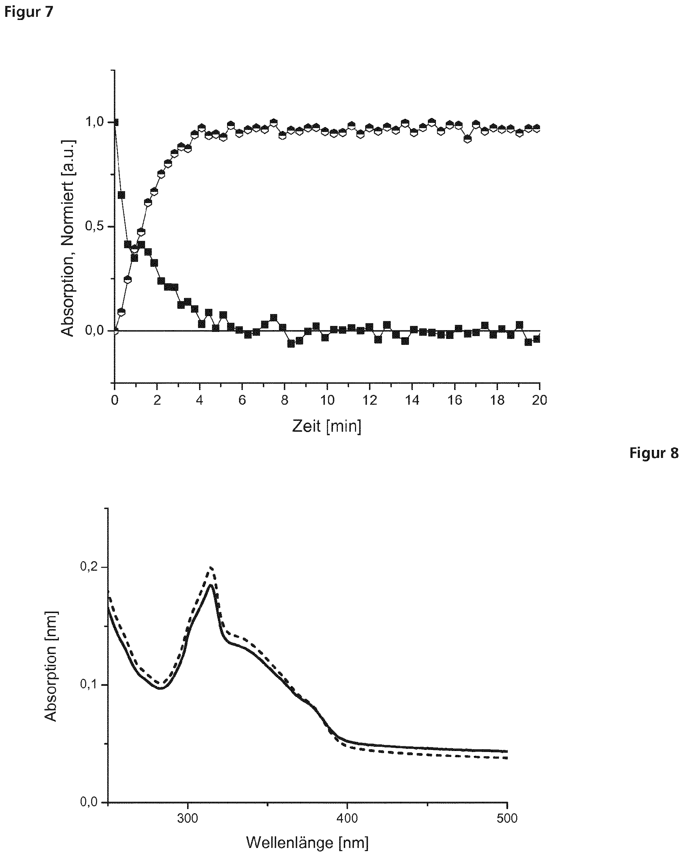

Die Vernetzungsreaktion kann mittels verschiedener Analysemethoden nachgewiesen werden. DSC -Untersuchungen der vernetzenden Substanzen zeigen einen stark ausgeprägten exothermen Peak im Bereich von 120 °C bis 200 °C (vergleiche Figur 5), der auf eine Vernetzungsreaktion schließen lässt. Mit isothermen FT-IR Messungen bei verschiedenen Temperaturen kann der Zerfall der oben genannten funktionellen Einheit bei 2250 cm-' (V_{CC-Dreifachbindung}) und das Entstehen des Produktes bei 1750 cm-' (v_{C=0}) über die Zeit nachgewiesen werden (Figur 6 (durchgezogene Linie: Reaktionsstart, gestrichelte Linie: Mitte der Reaktion, gepunktete Linie: Reaktionsende) und Figur 7 (schwarze Quadrate: 2250 cm⁻¹, schwarz-weiße Sechsecke: 1750 cm⁻¹)). Die Vernetzungsdauer ist bei 180 °C im Falle eines Moleküls mit drei Precursor-Einheiten ca. fünf Minuten abgeschlossen. Die Lösemittelbeständigkeit kann mittels UV-Messungen von beschichteten Quarzsubstraten nachgewiesen werden. Hierfür werden auf die Quarzsubstrate mittels Spin-coating für organisch-elektronische Bauteile übliche Schichtdicken im Bereich von 20 bis 80 nm aufgetragen und mittels UV Messungen, vor und nach dem Vernetzen, sowie nach dem Überspülen mit Lösemitteln, die Absorption bestimmt. Hierbei ist der Rückgang der Absorptionsbanden proportional zum heruntergelösten Polymer. In Figur 8 (gestrichelte Linie: vor dem Überspülen, durchgezogene Linie: nach dem Überspülen) ist dargestellt, dass bereits Vernetzeranteile im Copolymer von 13 M% zu Lösemittelbeständigen Filmen führen. In diesem Fall wurde Toluol als Lösemittel verwendet.

### Ausführungsbeispiel 14:

### Organischer Feldeffekttransistor

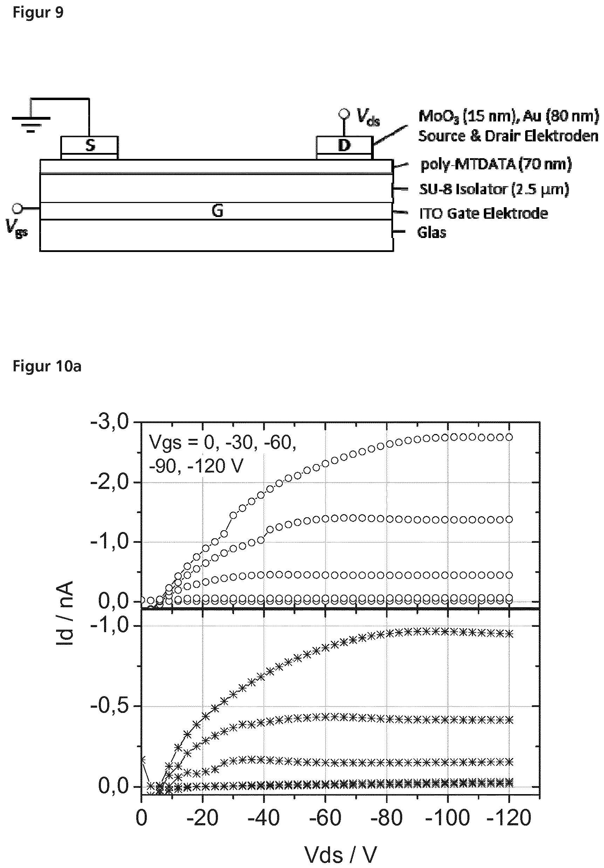

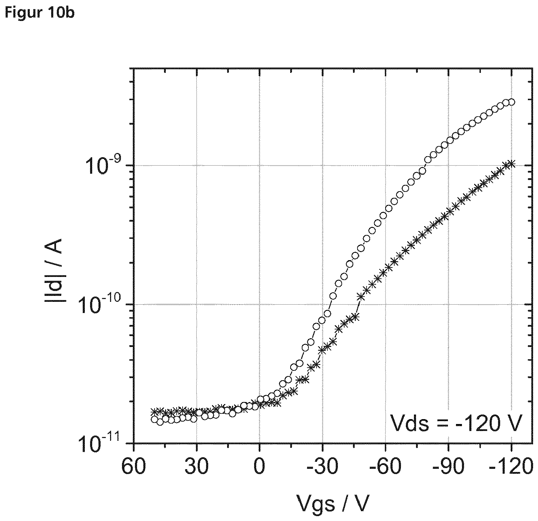

In Figur 9 ist der Aufbau eines getesteten organischen Feldeffekttransistors dargestellt. Figuren 10a (oben: poly-MTDATA, unten: vernetztes poly-MTDATA) und 10b (Kreise: poly-MTDATA, Kreuze: vernetztes poly-MTDATA) zeigen die Deviceeigenschaften hinsichtlich Leitfähigkeit und Mobilität von vernetzter und nicht vernetzter organisch-elektronischer Schicht. Der leichte Rückgang der Mobilität und der Leitfähigkeit im Bauteil mit vernetzter organisch-elektronischer Schicht wird auf die Verdünnung durch die Vernetzereinheit zurückgeführt.

### Ausführungsbeispiel 15:

### Organische Leuchtdiode (OLED)

### Beispiel 15a: Triplettemitter lösemittelprozessiert

Mit einem Vergleich von OLEDs mit einer lochtransportierenden Schicht mit und ohne Vernetzerkomponente, ausgeheizt und nicht ausgeheizt, soll der Einfluss der Vernetzergruppe auf die Eigenschaften von OLEDs zeigen. Hierzu wurde das lochleitende Seitengruppenpolymer 3,6-(BuO)₄TCTA mit der Vernetzergruppe copolymerisiert (gemäß Ausführungsbeispiel 5d) und mit dem Homopolymer (gemäß Ausführungsbeispiel 5e) in einem OLED-Teststack verglichen. Als Test-OLED wurde folgender Aufbau gewählt (die jeweiligen Schichtdicken sind in Klammern angegeben): ITO/PEDOT:PSS (35 nm)/ lochtransportierende Schicht (35 nm)/CBP:Ir(ppy)₃ (35 nm)/TPBi (20 nm)/LiF(0,7 nm)/Al (200 nm). Zuerst wurde PEDOT:PSS (Heraeus Clevios™ P VP Al 4083) flüssigprozessiert. Die lochleitenden Polymere wurden anschließend mittels Spin-coating aus einer Toluollösung flüssigprozessiert. Hierbei wurde die Konzentration (5 - 10 g/L) und Rotationsgeschwindigkeit (800 rpm - 2000 rpm) eingestellt, sodass eine Schichtdicke von 35 nm erreicht wurde. Das erfindungsgemäß vernetzbare (poly-3,6-(BuO)₄TCTA XL, OLED III) und das nicht vernetzbare (poly-3,6-(BuO)₄TCTA, OLED I) wurden zur Vergleichbarkeit einmal ohne thermische Behandlung in die OLED integriert. In zwei weiteren OLEDs wurden das erfindungsgemäß vernetzbare (poly-3,6-(BuO)₄TCTA XL hot; OLED IV) und das nicht vernetzbare (poly-3,6-(BuO)₄TCTA hot; OLED II) für 30 Minuten bei 160 °C auf einer abgedeckten vorgeheizten Heizplatte thermisch unter Stickstoffatmosphäre ausgeheizt. Die Temperatur und Dauer entspricht einem vollständigen Reaktionsumsatz der Vernetzergruppe. Die nachfolgenden Schichten wurden vakuumprozessiert um eine größtmögliche Vergleichbarkeit zu gewährleisten. Die Deviceergebnisse sind in Tabelle 1 dargestellt:

| | OLED I | OLED II (hot) | OLED III (XL) | OLED IV (XL hot) |
|---|---|---|---|---|
| Spannung bei 1000 cd/m² | 7,2 V | 7,6 V | 7,5 V | 7,5 V |
| Spannung bei 100 cd/m² | 5,1 V | 5,2 V | 5,2 V | 5,2 V |
| Spannung bei 10 cd/m² | 3,7 V | 3,7 V | 3,8 V | 3,7 V |
| Stromeffizienz bei 1000 cd/m² | 73,8 cd/A | 76,4 cd/A | 77,7 cd/A | 80,8 cd/A |
| Leistungseffizienz bei 1000 cd/m² | 32,2 lm/W | 31,7 lm/W | 32,6 lm/W | 33,7 lm/W |

Die Ergebnisse zeigen, dass die Vernetzergruppe einen leicht positiven Einfluss auf das OLED-Bauteil hat. Die OLEDs mit nicht vernetzbarer und vernetzbarer Lochtransportschicht liefern sowohl für die unbehandelten-, sowie für die ausgeheizten Schichten vergleichbare Kenndaten, die hinsichtlich der Effizienz für die vernetzten Lochtransportschichten sogar leicht verbesserte Werte liefern.

### Beispiel 15b: Singulettemitter lösemittelprozessiert

Es wurde eine OLED mit flüssigprozessierter fluoreszenter lichtemittierender Schicht unter Verwendung von F8BT (Poly[(9,9-dioctylfluorenyl-2,7-diyl)-alt-(benzo[2,1,3]thiadiazol-4,7-diyl)]) hergestellt: IT /PEDOT:PSS (75 nm)/ poly-3,6-(BuO)₄TCTA XL hot (1-5 nm)/F8BT (35 nm)/Ca (20 nm)/Ag (40 nm) (OLED VI). Zuerst wurde PEDOT:PSS (Heraeus Clevios™ P VP Al 4083) flüssigprozessiert. Das lochleitende Polymer wurde anschließend mittels Spin-coating aus einer Toluollösung flüssigprozessiert. Hierbei wurde die Konzentration (5 g/L) und die Rotationsgeschwindigkeit (2000 rpm - 4000 rpm) eingestellt, sodass eine Schichtdicke von ca. 5 nm erreicht wurde. Das vernetzbare Polymer (poly-3,6-(BuO)4TCTA XL) wurde für 30 Minuten bei 160 °C auf einer abgedeckten vorgeheizten Heizplatte thermisch unter Stickstoffatmosphäre ausgeheizt. Die Temperatur und Dauer entspricht einem vollständigen Reaktionsumsatz der Vernetzergruppe. Ein Teststack ohne zusätzliche vernetzbare lochleitende Schicht dient als Vergleichs-OLED: ITO/PEDOT:PSS (75 nm)/F8BT (35 nm)/Ca (20 nm)/Ag (40 nm) (OLED V). Die Ergebnisse zeigt Tabelle 2:

| | OLED V | OLED VI |
|---|---|---|
| Spannung bei 1000 cd/m² | 4,5 V | 4,6 V |
| Spannung bei 100 cd/m² | 3,7 V | 3,9 V |
| Spannung V bei 10 cd/m² | 3,4 V | 3,5 V |
| Stromeffizienz bei 1000 cd/m² | 0,6 cd/A | 2,3 V cd/A |
| Leistungseffizienz bei 1000 cd/m² | 0,4 lm/W | 1,6 lm/W |

Bereits die Einbringung einer sehr dünnen zusätzlichen vernetzten Lochtransportschicht führt zu einer deutlichen Verbesserung der OLEDs.

## Patentansprüche

1. Organisch-elektronisches Bauteil, umfassend ein Substrat (1), zumindest eine erste Elektrodenschicht (2) und eine zweite Elektrodenschicht (4) und zumindest eine erste, zwischen der ersten (2) und der zweiten Elektrodenschicht (4) angeordnete organisch-elektronische Funktionsschicht, die ein vernetztes Polymer umfasst oder hieraus besteht, **dadurch gekennzeichnet, dass** das vernetzte Polymer substituierte 3-Alkoxycyclobut-2-en-1-on-Gruppen enthält.

2. Bauteil nach dem vorhergehenden Anspruch, wobei die organisch-elektronische Funktionsschicht im Falle einer OLED zumindest eine strahlungsemittierende Schicht (5) oder im Falle einer OPVC eine Absorberschicht oder eine Akzeptorschicht oder im Falle eines OFET eine Halbleiterschicht (31) aufweist.

3. Bauteil nach einem der vorhergehenden Ansprüche, **dadurch gekennzeichnet dass** die Funktionsschicht keine Radikalstarter oder Photoinitiatoren oder deren Zerfallsprodukte enthält.

4. Bauteil nach einem der vorhergehenden Ansprüche, **dadurch gekennzeichnet, dass** die zweite Elektrodenschicht (4) und das Substrat (1) auf gegenüberliegenden Seiten der zumindest einer ersten organisch-elektronischen Funktionsschicht angeordnet sind und dass zwischen der organisch-elektronischen Funktionsschicht und der zweiten Elektrodenschicht (4) eine weitere organisch-elektronische Funktionsschicht angeordnet ist.

5. Bauteil nach einem der vorhergehenden Ansprüche, **dadurch gekennzeichnet dass** das vernetzte Polymer ein Blend aus mindestens zwei polymeren Komponenten enthält.

6. Alkinylether, der Formel R²R³CH-CR⁴R⁵-O-C≡C-R¹ worin
- R², R³, R⁴ und R⁵ jeweils unabhängig voneinander ausgewählt ist aus der Gruppe bestehend aus linearen, verzweigten, zyklischen Alkyl-Resten oder aromatischen Resten, die substituiert oder unsubstituiert sein können und Wasserstoff **dadurch gekennzeichnet, dass**
R¹ entweder ein substituierter Aryl oder Heteroaryl-Rest mit einem Molekulargewicht von 250 bis 2500 g/mol, bevorzugt von 400 bis 900 g/mol, ist wobei der Aryl oder Heteroaryl-Rest zwei, drei oder mehr Alkinylethergruppen R²R³CH-CR⁴R⁵-O-C≡C- enthält, wobei der Aryl- oder Heteroaryl-Rest ausgewählt ist aus Triarylaminen, Chinolinderivaten, Bathocuproinderivaten, Perylenderivaten, Benzimidazolderivaten, Oxadiazolderivaten, Phenanthrolinderivaten, Triazolderivaten, Carbazolderivaten, Bipyridinderivaten, Pyrimidinderivaten, Fluorenderivaten, Polyanilinen, Polyethylendioxythiophenen, Phthalocyaninen und aus Verbindungen, die zwei oder mehr der genannten Gruppen enthalten, oder durch eine Gruppe -L-Z gebildet ist, in der L eine Einfachbindung, ein gegebenenfalls substituierter Alkylen-, Arylen- oder Heteroarylen-Linker ist und Z ein nicht vernetztes Polymer ist.

7. Alkinylether nach dem vorhergehenden Anspruch **dadurch gekennzeichnet, dass** R¹ entweder ein substituierter oder unsubstituierter Aryl oder Heteroaryl-Rest ist, der eine polymerisierbare Gruppe enthält,
oder durch eine Gruppe -L-Z gebildet ist, in der L eine Einfachbindung, ein gegebenenfalls substituierter Alkylen-, Arylen- oder Heteroarylen-Linker ist und Z ein nicht vernetztes Polymer ist
und wobei R¹ zudem zwei, drei oder mehr Alkinylethergruppen R²R³CH-CR⁴R⁵-O-C≡C- enthält.

8. Alkinylether nach einem der beiden vorhergehenden Ansprüche wobei R³ oder R⁴ Wasserstoff, ein Aryl-Rest mit bis zu 12 Kohlenstoff-Atomen oder ein Alkyl-Rest, insbesondere Wasserstoff, Methyl, Ethyl, n-Propyl, i-Propyl, Phenyl oder t-Butyl und R², R⁵ und der andere der Substituenten R³ und R⁴ Wasserstoff ist.

## Claims

1. Organoelectronic component comprising a substrate (1), at least one first electrode layer (2) and a second electrode layer (4) and at least one first organoelectronic functional layer arranged between the first electrode layer (2) and the second electrode layer (4) which comprises or consists of a crosslinked polymer, **characterized in that** the crosslinked polymer contains substituted 3-alkoxycyclobut-2-en-1-one groups.

2. Component according to the preceding claim, wherein the organoelectronic functional layer comprises in the case of an OLED at least one radiation-emitting layer (5) or in the case of an OPVC an absorber layer or an acceptor layer or in the case of an OFET a semiconductor layer (31).

3. Component according to either of the preceding claims, **characterized in that** the functional layer contains no free-radical initiators or photoinitiators or decomposition products thereof.

4. Component according to any of the preceding claims, **characterized in that** the second electrode layer (4) and the substrate (1) are arranged on opposite sides of the at least one first organoelectronic functional layer and **in that** a further organoelectronic functional layer is arranged between the organoelectronic functional layer and the second electrode layer (4).

5. Component according to any of the preceding claims, **characterized in that** the crosslinked polymer contains a blend of at least two polymeric components.

6. Alkynyl ether of formula R²R³CH-CR⁴R⁵-O-C≡C-R¹ wherein
- R², R³, R⁴ and R⁵ are in each case independently of one another selected from the group consisting of linear, branched, cyclic alkyl radicals or aromatic radicals, which may be substituted or unsubstituted, and hydrogen, **characterized in that**
R¹ is either a substituted aryl or heteroaryl radical having a molecular weight of 250 to 2500 g/mol, preferably of 400 to 900 g/mol, wherein the aryl or heteroaryl radical contains two, three or more alkynyl ether groups R²R³CH-CR⁴R⁵-O-C≡C-, wherein the aryl or heteroaryl radical is selected from triarylamines, quinoline derivatives, bathocuproine derivatives, perylene derivatives, benzimidazole derivatives, oxadiazole derivatives, phenanthroline derivates, triazole derivates, carbazole derivates, bipyridine derivates, pyrimidine derivatives, fluorene derivatives, polyanilines, polyethylenedioxythiophenes, phthalocyanines and from compounds containing two or more of the recited groups or is formed by a group -L-Z in which L is a single bond, an optionally substituted alkylene, arylene or heteroarylene linker and Z is an uncrosslinked polymer.

7. Alkynyl ether according to the preceding claim, **characterized in that** R¹ is either a substituted or unsubstituted aryl or heteroaryl radical which contains a polymerizable group or is formed by a group -L-Z in which L is a single bond, an optionally substituted alkylene, arylene or heteroarylene linker and Z is an uncrosslinked polymer and wherein R¹ additionally contains two, three or more alkynyl ether groups R²R³CH-CR⁴R⁵-O-C≡C-.

8. Alkynyl ether according to any of the two preceding claims, wherein R³ or R⁴ is hydrogen, an aryl radical having up to 12 carbon atoms or an alkyl radical, in particular hydrogen, methyl, ethyl, n-propyl, i-propyl, phenyl or t-butyl, and R², R⁵ and the other one of the substituents R³ and R⁴ is hydrogen.

## Revendications

1. Élément électronique organique, comprenant un substrat (1), au moins une première couche d'électrodes (2) et une deuxième couche d'électrodes (4) et au moins une première couche fonctionnelle électronique organique disposée entre la première (2) et la deuxième couche d'électrodes (4), qui comprend un polymère réticulé ou qui en est constituée, **caractérisé en ce que** le polymère réticulé contient des groupes 3-alcoxycyclobut-2-èn-1-one substitués.

2. Élément selon la revendication précédente, la couche fonctionnelle électronique organique, dans le cas d'une OLED, présentant au moins une couche (5) émettrice de radiation ou, dans le cas d'une OPVC, une couche d'absorbeur ou une couche d'accepteur ou, dans le cas d'un OFET, une couche de semi-conducteur (31).

3. Élément selon l'une des revendications précédentes, **caractérisé en ce que** la couche fonctionnelle ne contient pas d'initiateur de radicaux ni de photoinitiateurs ni leurs produits de dégradation.

4. Élément selon l'une des revendications précédentes, **caractérisé en ce que** la deuxième couche d'électrodes (4) et le substrat (1) sont disposés sur des faces opposées de l'au moins une première couche fonctionnelle électronique organique et qu'entre la couche fonctionnelle électronique organique et la deuxième couche d'électrodes (4), est disposée une autre couche fonctionnelle électronique organique.

5. Élément selon l'une des revendications précédentes, **caractérisé en ce que** le polymère réticulé contient un mélange d'au moins deux composants polymères.

6. Éther d'alcynyle, de formule R²R³CH-CR⁴R⁵-O-C≡C-R¹ dans laquelle
- R², R³, R⁴ et R⁵ à chaque fois indépendamment les uns des autres, sont choisis dans le groupe constitué par des radicaux alkyle linéaires, ramifiés ou cycliques ou des radicaux aromatiques, qui peuvent être substitués ou non substitués, et hydrogène, **caractérisé en ce que** R¹ est soit un radical aryle ou hétéroaryle, substitué, présentant un poids moléculaire de 250 à 2500 g/mole, préférablement de 400 à 900 g/mole, le radical aryle ou hétéroaryle contenant deux, trois groupes éther d'alcynyle R²R³CH-CR⁴R⁵-O-C≡C- ou plus, le radical aryle ou hétéroaryle étant choisi parmi des triarylamines, des dérivés de quinoléine, des dérivés de bathocuproine, des dérivés de pérylène, des dérivés de benzoimidazole, des dérivés d'oxadiazole, des dérivés de phénantroline, des dérivés de triazole, des dérivés de carbazole, des dérivés de bipyridine, des dérivés de pyrimidine, des dérivés de fluorène, des polyanilines, des polyéthylènedioxythiophènes, des phtalocyanines et parmi des composés qui contiennent deux des groupes indiqués ou plus,
soit est formé d'un groupe -L-Z, dans lequel L est une simple liaison, un lieur alkylène, arylène ou hétéroarylène, éventuellement substitué et Z est un polymère non réticulé.

7. Éther d'alcynyle selon la revendication précédente, **caractérisé en ce que** R¹ est soit un radical aryle ou hétéroaryle, substitué ou non substitué, qui contient un groupe polymérisable, soit est formé d'un groupe -L-Z, dans lequel L est une simple liaison, un lieur alkylène, arylène ou hétéroarylène, éventuellement substitué et Z est un polymère non réticulé
et R¹ contenant de plus deux, trois groupes éther d'alcynyle R²R³CH-CR⁴R⁵-O-C≡C- ou plus.

8. Éther d'alcynyle selon l'une des deux revendications précédentes, R³ ou R⁴ étant hydrogène, un radical aryle comportant jusqu'à 12 atomes de carbone ou un radical alkyle, en particulier hydrogène, méthyle, éthyle, n-propyle, i-propyle, phényle ou t-butyle et R², R⁵ et l'autre des substituants R³ et R⁴ étant hydrogène.
